# EUROPEAN PATENT APPLICATION

(11) **EP 4 686 344 A1**
(43) Date of publication of application: **28.01.2026**
(21) Application number: 25163406.9
(22) Date of filing: 13.03.2025
(51) Int. Cl.: H10D 84/00, H10D 12/01, H10D 12/00, H10D 84/80, H10D 30/01, H10D 30/47, H10D 8/01

(54) **SEMICONDUCTOR DEVICE AND ELECTRONIC SYSTEM INCLUDING THE SAME**

(30) Priority: 25.07.2024 KR 20240098925
(71) Applicant: Samsung Electronics Co., Ltd., Suwon-si, Gyeonggi-do 16677 (KR)
(72) Inventor: PARK, Junhyuk, Suwon-si (KR); HWANG, In Jun, Suwon-si (KR)
(74) Representative: Marks & Clerk LLP

(57) **Abstract**

A semiconductor device includes: a substrate and backward and forward diodes. Each backward diodes includes: a first channel layer; a first barrier layer; a first gate electrode; a first gate semiconductor layer; and a first source electrode and a first drain electrode that are disposed at opposite sides of the first gate electrode. The forward diode includes: a second channel layer; a second barrier layer; a second gate electrode; a second gate semiconductor layer; and a second source electrode and a second drain electrode that are disposed at opposite sides of the second gate electrode. The second source electrode is connected to the second gate electrode, and a first drain electrode of the backward diodes is connected with a second source electrode of the forward diode. The band gaps of the first (second) channel layer and the first (second) barrier layers are different.

## Description

### BACKGROUND

Electric power semiconductor devices are used in various fields, such as transportation (e.g., electric vehicles, railways, and electric trams), renewable energy systems (e.g., solar power generation and wind power generation), and mobile devices. Electric power semiconductor devices are used to handle a high voltage or high current and perform various functions, such as electric power conversion and control in large electric power systems or high-power electronic devices. Electric power semiconductor devices can handle high electric power and have durability, e.g., handle large amounts of current and withstand high voltage. For example, electric power semiconductor devices may handle voltages from hundreds to thousands of volts and currents from tens to thousands of amperes. Electric power semiconductor devices can improve the efficiency of electrical energy by minimizing power loss. In addition, electric power semiconductor devices can operate stably in diverse environments, such as high temperatures.

Electric power semiconductor devices can be classified according to material, such as SiC electric power semiconductor devices and GaN electric power semiconductor devices. In certain examples, manufacturing an electric power semiconductor device using SiC or GaN, instead of silicon (Si), may offer various benefits. SiC electric power semiconductor devices are resistant to high temperatures, have low power loss, and may be suitable for electric vehicles and renewable energy systems. Though GaN electric power semiconductor devices are expensive, GaN electric power semiconductor devices may be efficient in terms of speed and can be suitable for high-speed charging of a mobile device.

### SUMMARY

The present disclosure provides a semiconductor device that can perform a function or functions of a Zener diode by including a plurality of backward diodes and at least one forward diode, as well as an electronic system including the same.

An aspect of the invention is described at Claim 1.

A first general aspect includes a semiconductor device including: a substrate; and a plurality of backward diodes connected with each other and at least one forward diode connected with any one of the plurality of backward diodes, the plurality of backward diodes and the at least one forward diode disposed on the substrate, wherein each of the plurality of backward diodes includes: a first channel layer disposed on the substrate; a first barrier layer that is disposed on the first channel layer and includes a material having an energy bandgap that is different from an energy band gap of the first channel layer; a first gate electrode disposed on the first barrier layer; a first gate semiconductor layer disposed between the first barrier layer and the first gate electrode; and a first source electrode and a first drain electrode that are disposed at opposite sides of the first gate electrode and connected to the first channel layer, the first source electrode is connected with the first gate electrode, the at least one forward diode each includes: a second channel layer disposed on the substrate; a second barrier layer that is disposed on the second channel layer and includes a material of which an energy band gap is different from an energy band gap of the second channel layer; a second gate electrode disposed on the second barrier layer; a second gate semiconductor layer disposed between the second barrier layer and the second gate electrode; and a second source electrode and a second drain electrode that are disposed at opposite sides of the second gate electrode and connected to the second channel layer, the second source electrode is connected to the second gate electrode, and a first drain electrode of any one of the plurality of backward diodes is connected with a second source electrode of any one of the at least one forward diode.

A second general aspect includes a semiconductor device including: a substrate; a first electrode, a second electrode, and a third electrode that are disposed apart from each other on the substrate; a plurality of backward diodes connecting the first electrode and the second electrode; and at least one forward diode connecting the second electrode and the third electrode, wherein each of the plurality of backward diodes includes: a first channel layer disposed on the substrate; a first barrier layer that is disposed on the first channel layer and includes a material of which an energy band gap is different from an energy band gap of the first channel layer; a first gate electrode disposed on the first barrier layer; a first gate semiconductor layer disposed between the first barrier layer and the first gate electrode; and a first source electrode and a first drain electrode that are disposed at opposite sides of the first gate electrode and connected to the first channel layer, the first source electrode is connected with the first gate electrode, each of the at least one forward diode includes: a second channel layer that is disposed on the substrate and includes the same material as a material of the first channel layer; a second barrier layer that is disposed on the second channel layer and includes the same material as a material of the first barrier layer; a second gate electrode that is disposed on the second barrier layer; a second gate semiconductor layer that is disposed between the second barrier layer and the second gate electrode and includes the same material as a material of the first gate semiconductor layer; and a second source electrode and a second drain electrode that are disposed at opposite sides of the second gate electrode and connected to the second channel layer, the second source electrode is connected with the second gate electrode, a first source electrode of any one of the plurality of backward diodes is connected with the first electrode, a first drain electrode of the other one of the plurality of backward diodes is connected with the second electrode and a second source electrode of any one of the at least one forward diode, and a second drain electrode of any one of the at least one forward diode is connected with the third electrode.

A third general aspect includes an electronic system including: a substrate; a semiconductor device that is disposed on the substrate, and includes a plurality of backward diodes connected with each other and at least one forward diode connected with any one of the plurality of backward diodes; and a main transistor element that is electrically connected with the semiconductor device on the substrate, wherein each of the plurality of backward diodes includes: a first channel layer disposed on the substrate and containing GaN; a first barrier layer disposed on the first channel layer and containing AlGaN; a first gate electrode disposed on the first barrier layer; a first gate semiconductor layer that is disposed between the first barrier layer and the first gate electrode and contains GaN doped with a P-type impurity; and a first source electrode and a first drain electrode that are disposed at opposite sides of the first gate electrode and connected with the first channel layer, the first source electrode is connected with the first gate electrode, each of the at least one forward diode includes: a second channel layer that is disposed on the substrate and contains GaN; a second barrier layer that is disposed on the second channel layer and contains AlGaN; a second gate electrode disposed on the second barrier layer; a second gate semiconductor layer that is disposed between the second barrier layer and the second gate electrode, and contains GaN doped with a P-type impurity; and a second source electrode and a second drain electrode that are disposed at opposite sides of the second gate electrode and connected with the second channel layer, the second source electrode is connected with the second gate electrode, a first drain electrode of any one of the plurality of backward diodes is connected with a second source electrode of any one of the at least one forward diode, and the main transistor element includes: a main channel layer that is disposed on the substrate and includes the same material as a material of the first channel layer; a main barrier layer that is disposed on the main channel layer and includes the same material as a material of the first barrier layer; a main gate electrode disposed on the main barrier layer; a main gate semiconductor layer disposed between the main barrier layer and the main gate electrode; and a main source electrode and a main drain electrode that are disposed at opposite sides of the main gate electrode, connected with the main channel layer, and include the same materials as a material of the first source electrode and a material of the first drain electrode.

In some implementations, a semiconductor device and an electronic system including the same can perform a function of a Zener diode.

At least some of the above and other features of the invention are set out in the claims.

### BRIEF DESCRIPTION OF THE DRAWINGS

FIG. 1 is a circuit diagram of an example of a semiconductor device.
FIG. 2 and FIG. 3 are cross-sectional views of an example of a diode unit of the semiconductor device of FIG. 1.
FIG. 4 is a cross-sectional view of FIG. 1, taken along the line A-A'.
FIG. 5 is a cross-sectional view of the flow of the current of the semiconductor device, corresponding to the line A-A' of FIG. 1.
FIG. 6 shows the intensity of the current of the semiconductor device versus a difference in voltages applied to the semiconductor device.
FIG. 7 to FIG. 10 are cross-sectional views of an example of a semiconductor device, taken along the line A-A' of FIG. 1.
FIG. 11 to FIG. 14 are top plan views of an example of a semiconductor device.
FIG. 15 is a top plan view of an example of an electronic system including a semiconductor device.
FIG. 16 and FIG. 17 are cross-sectional views of FIG. 15, taken along the line B-B'.

### DETAILED DESCRIPTION

For the diode structures described below, in at least some embodiments, the use of "source" or "drain" is used to identify one source/drain region over another source/drain region, and it may be that a source is a drain and vice versa depending on the context.

In order to clearly explain the present disclosure, parts that are not related to the description are omitted, and the same reference symbols are used for identical or similar components throughout the specification.

In addition, the size and thickness of each component shown in the drawings are arbitrarily shown for better understanding and ease of description, and therefore the present disclosure is not necessarily limited to what is shown. In the drawings, the thickness of layers, films, panels, regions, and the like are exaggerated for clarity. In addition, in the drawings, for better understanding and ease of description, the thickness of some layers and regions is exaggerated.

In addition, it will be understood that when an element such as a layer, film, region, or substrate is referred to as being "on" another element, it can be directly on the other element or intervening elements may also be present. In contrast, when an element is referred to as being "directly on" another element, there are no intervening elements present. Further, throughout the specification, the word "on" a target element will be understood to mean positioned above or below the target element and will not necessarily be understood to mean positioned "at an upper side" based on an opposite to gravity direction.

Further, throughout the specification, the phrase "on a plane" means viewing a target portion from the top, and the phrase "on a cross-section" means viewing a cross-section formed by vertically cutting a target portion from the side.

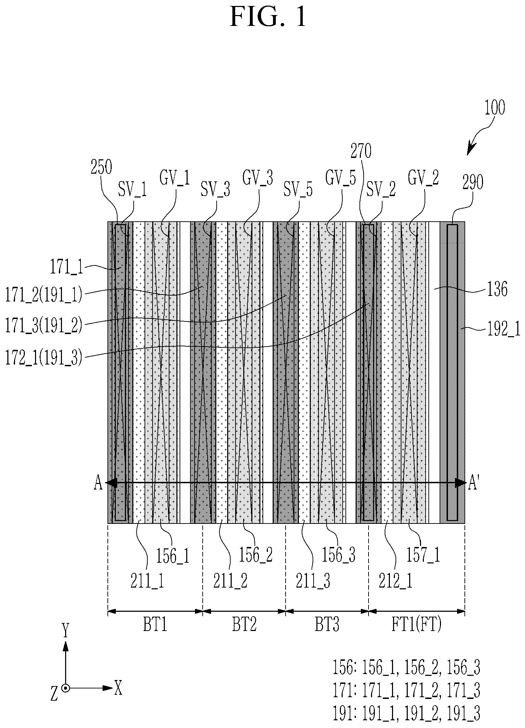

Hereinafter, referring to FIG. 1 to FIG. 4, a circuit structure of a semiconductor device will be described.

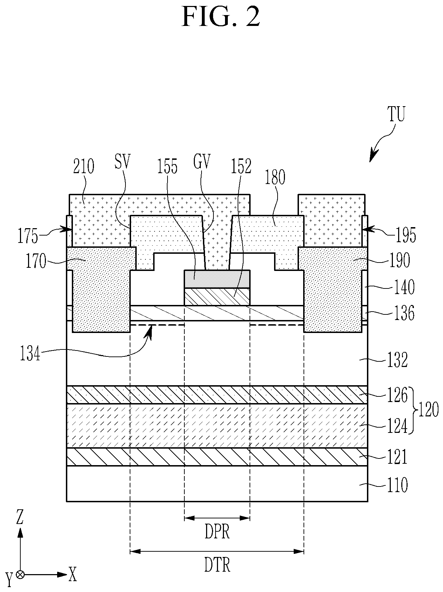

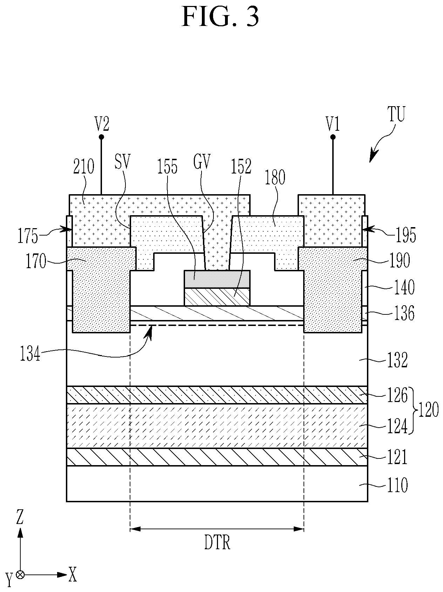

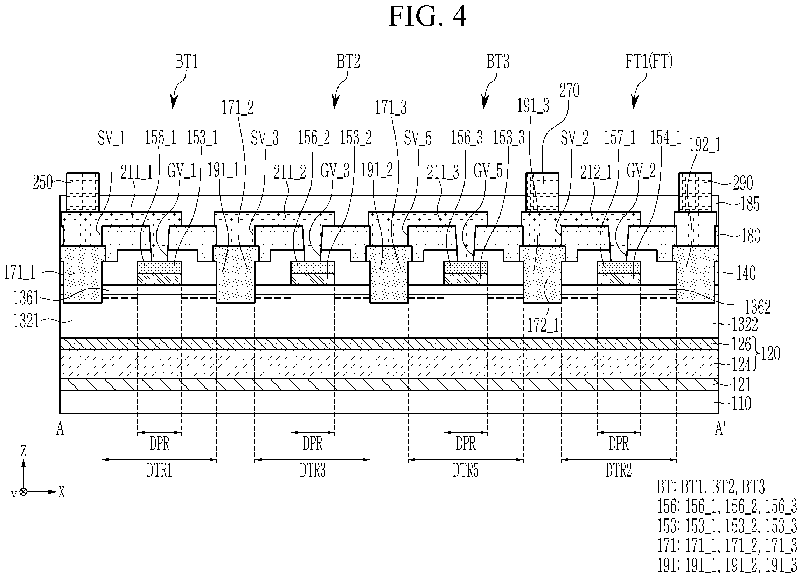

FIG. 1 is a circuit diagram of an example of a semiconductor device. FIG. 2 and FIG. 3 are cross-sectional views of a diode unit of the semiconductor device. FIG. 4 is a cross-sectional view of FIG. 1, taken along the line A-A'. FIG. 2 shows a case in which the diode unit of the semiconductor device is in an off state. FIG. 3 shows a case in which the diode unit of the semiconductor device is in an on state.

Referring to FIG. 1, a semiconductor device 100 may be a normally-off high electron mobility transistor (HEMT). However, the present disclosure is not limited thereto, and the semiconductor device 100 may be a normally-on HEMT. The semiconductor device 100 may serve as a Zener diode. Here, the Zener diode may mean a device that has the same characteristics as a general diode device in the forward voltage region, but a backward current flows at a lower voltage (breakdown voltage) compared to a general diode device in the backward voltage region.

The semiconductor device 100 may include a plurality of diode devices. For example, the semiconductor device 100 may include a plurality of backward diodes BT and at least one forward diode FT. The plurality of backward diodes BT and the at least one forward diode FT may have the same structure. That is, the plurality of backward diodes BT and the at least one forward diode FT each may be formed of at least one diode unit TU (refer to FIG. 2).

Hereinafter, a diode unit forming the semiconductor device will be described with reference to FIG. 2 and FIG. 3.

Referring to FIG. 2, the semiconductor device includes a plurality of diode units TU.

The diode unit TU of the semiconductor device may include a substrate 110, a channel layer 132 disposed on the substrate 110, a barrier layer 136 disposed on the channel layer 132, a gate electrode 155 disposed on the barrier layer 136, a gate semiconductor layer 152 disposed between the barrier layer 136 and the gate electrode 155, a source electrode 170 and a drain electrode 190 disposed apart from each other on the barrier layer 136, and a connection wire 210 connecting the source electrode 170 and the gate electrode 155. In the implementations illustrated herein, the phrases "source electrode" and "drain electrode" may be understood to mean a source terminal region and a drain terminal region, respectively, of either of a transistor, e.g., semiconductor device 100.

The channel layer 132 is a layer forming a channel between the source electrode 170 and the drain electrode 190, a two-dimensional electron gas (2DEG) 134 may be disposed inside the channel layer 132. The 2DEG 134 is a charge transport model used in solid physics, which refers to a group of electrons that can move freely in two dimensions (e.g., the x-y planar direction), but cannot move in the other dimension (e.g., the z direction) and are tightly bound within the two dimensions. That is, the 2DEG 134 may exist in a two-dimensional planar form within a three-dimensional space. Such 2DEG 134 often appear in semiconductor heterojunction structures and may occur at the interface between the channel layer 132 and the barrier layer 136 in the diode unit TU of the semiconductor device. For example, the 2DEG 134 may occur adjacent to the barrier layer 136 within the channel layer 132.

The channel layer 132 may include one or more materials selected from group III-V materials, for example, nitrides including Al, Ga, In, B, or a combination thereof. The channel layer 132 may be formed of a single layer or multiple layers. The channel layer 132 may be AlₓIn_{y}Ga_{1-x-y}N (0≤x≤1, 0≤y≤1, x+y≤1). For example, the channel layer 132 may include AlN, GaN, InN, InGaN, AlGaN, AlInN, AlInGaN, or a combination thereof. The channel layer 132 may be an impurity doped layer or an undoped layer. A thickness of the channel layer 132 may be less than several hundred nm.

The channel layer 132 may be disposed on the substrate 110, and a seed layer 121 and a buffer layer 120 may be disposed between the substrate 110 and the channel layer 132. The substrate 110, the seed layer 121, and the buffer layer 120 form the channel layer 132, and may be omitted in some cases. For example, when a substrate made of GaN is used as the channel layer 132, at least one of the substrate 110, the seed layer 121, and the buffer layer 120 may be omitted. Since the substrate made of GaN is relatively expensive, a channel layer 132 including GaN can be grown using a substrate 110 made of Si. In this case, it may not be easy to grow the channel layer 132 directly on the substrate 110 because the lattice structure of Si and the lattice structure of GaN are different. Accordingly, the seed layer 121 and the buffer layer 120 may be grown first on the substrate 110, and then the channel layer 132 may be grown on the buffer layer 120. In addition, at least one of the substrate 110, the seed layer 121, and the buffer layer 120 may be removed from the final structure of the diode unit TU of the semiconductor device after being used in the manufacturing process. It will be understood that other materials besides Si, or in addition to Si, may be used and the use of Si for the substrate 110 is an example. The growing of GaN is also an example, and other materials may be used.

The substrate 110 may include a semiconductor material. For example, the substrate 110 may include sapphire, Si, SiC, AlN, GaN, or a combination thereof. The substrate 110 may be a silicon on insulator (SOI) substrate. However, the material of the substrate 110 is not limited to this, and all generally-used substrates is applicable. In some cases, the substrate 110 may also include an insulating material. For example, multiple layers including the channel layer 132 may be first formed on the semiconductor substrate, and then the semiconductor substrate can be removed and replaced with an insulation substrate.

The seed layer 121 may be directly disposed on the substrate 110. However, the present disclosure is not limited thereto, and another predetermined layer may be disposed between the substrate 110 and the seed layer 121. The seed layer 121 is a layer that serves as a seed for growing the buffer layer 120, and may be formed of a crystal lattice structure that serves as the seed of the buffer layer 120. The buffer layer 120 may be disposed directly above the seed layer 121. However, the present disclosure is not limited thereto, and other predetermined layers may be disposed between the seed layer 121 and the buffer layer 120. The seed layer 121 may include one or more materials selected from group III-V materials, for example, nitrides including Al, Ga, In, B, or a combination thereof. The seed layer 121 may be AlₓIn_{y}Ga_{1-x-y}N (0≤x≤1, 0≤y≤1, x+y≤1). For example, the seed layer 121 may include AlN, GaN, InN, InGaN, AlGaN, AlInN, AlInGaN, or a combination thereof.

The buffer layer 120 may be disposed above the seed layer 121. The buffer layer 120 may be disposed between the seed layer 121 and the channel layer 132. The buffer layer 120 may be a layer to alleviate a difference in lattice constant and thermal expansion coefficient between the seed layer 121 and the channel layer 132, or to prevent parasitic current (leakage current) from flowing through the channel layer 132. The buffer layer 120 may include one or more materials selected from group III-V materials, for example, nitrides including Al, Ga, In, B, or a combination thereof. The buffer layer 120 may be AlₓIn_{y}Ga_{1-x-y}N (0≤x≤1, 0≤y≤1, x+y≤1). For example, the buffer layer 120 may include AlN, GaN, InN, InGaN, AlGaN, AlInN, AlInGaN, or a combination thereof.

The buffer layer 120 of the diode unit TU of the semiconductor device may include a superlattice layer 124 disposed on the seed layer 121, and a high-resistive layer 126 disposed on the superlattice layer 124. The superlattice layer 124 and the high-resistive layer 126 may be sequentially disposed on the substrate 110.

The superlattice layer 124 may be disposed on the seed layer 121. The superlattice layer 124 may be disposed directly on the seed layer 121. However, this is not restrictive, and a predetermined another layer may further be disposed between the seed layer 121 and the superlattice layer 124. The superlattice layer 124 may be a layer that alleviates a difference in lattice constant and thermal expansion coefficient between the substrate 110 and the channel layer 132, thereby alleviating the tensile stress and compressive stress generated between the substrate 110 and the channel layer 132, and alleviates the stress between entire layers formed by growth in the final structure of the diode unit TU of the semiconductor device. The superlattice layer 124 may include one or more materials selected from group III-V materials, for example, nitrides including Al, Ga, In, B, or a combination thereof. The superlattice layer 124 may be AlₓIn_{y}Ga_{1-x-y}N (0≤x≤1, 0≤y≤1, x+y≤1). For example, the superlattice layer 124 may include AlN, GaN, InN, InGaN, AlGaN, AlInN, AlInGaN, or a combination thereof.

In some implementations, the superlattice layer 124 may be formed of multiple layers of alternating layers containing different materials. For example, the superlattice layer 124 may have a structure in which layers made of AlGaN and layers made of AlN are repeatedly stacked. That is, AlGaN/AlN/AlGaN/AlN/AlGaN/AlN may be sequentially stacked such that a superlattice layer can be formed. The number of AlGaN layers and GaN constituting the superlattice layer 124 may be varied, and the material constituting the superlattice layer 124 may be varied. As another example, the superlattice layer 124 may have a structure in which layers made of AlGaN and layers made of GaN are repeatedly stacked. That is, AlGaN/GaN/AlGaN/GaN/AlGaN/GaN may be sequentially stacked to form a superlattice layer. In some implementations, when the superlattice layer 124 includes GaN, InN, AlGaN, AlInN, InGaN, AlN, AlInGaN, or a combination thereof, the superlattice layer 124 may have an N-type semiconductor characteristic in which the concentration of electrons is greater than the concentration of holes, but the present disclosure is not limited thereto.

The high-resistive layer 126 may be disposed on the superlattice layer 124. The high-resistive layer 126 may be disposed directly on the superlattice layer 124. However, the present disclosure is not limited thereto, and another predetermined layer may be disposed between the superlattice layer 124 and the high-resistive layer 126. The high-resistive layer 126 may be disposed between the superlattice layer 124 and the channel layer 132. The high-resistive layer 126 is a layer that prevents degradation of the diode unit TU of the semiconductor device by preventing leakage current from flowing through the channel layer 132. The high-resistive layer 126 may be formed of a low-conductivity material such that a space between the substrate 110 and the channel layer 132 can be electrically insulated. The high-resistive layer may include one or more materials selected from group III-V materials, for example, nitrides including Al, Ga, In, B, or a combination thereof. The high-resistive layer 126 may be AlₓIn_{y}Ga_{1-x-y}N (0≤x≤1, 0≤y≤1, x+y≤1). For example, the high-resistive layer 126 may include AlN, GaN, InN, InGaN, AlGaN, AlInN, AlInGaN, or a combination thereof. The high-resistive layer 126 may be composed of a single layer or multiple layers.

The barrier layer 136 may be disposed on the channel layer 132. The barrier layer 136 may be disposed directly on the channel layer 132. However, the present disclosure is not limited thereto, and another predetermined layer may be disposed between the channel layer 132 and the barrier layer 136. A region of the channel layer 132, overlapping the barrier layer 136 between the source electrode 170 and the drain electrode 190 may be a main drift region DTR. The drift region DTR may be disposed between the source electrode 170 and the drain electrode 190. The drift region DTR may mean a region where carriers move when a potential difference occurs between the source electrode 170 and the drain electrode 190.

The diode unit TU of the semiconductor device may be turned on/off depending on whether a voltage is applied to the gate electrode 155 and/or the magnitude of the voltage applied to the gate electrode 155, and accordingly, the movement of carriers in the drift region DTR may be allowed or blocked.

The barrier layer 136 may include one or more materials selected from group III-V materials, for example, nitrides including Al, Ga, In, B, or a combination thereof. The barrier layer 136 may be AlₓIn_{y}Ga_{1-x-y}N (0≤x≤1, 0≤y≤1, x+y≤1). The barrier layer 136 may include GaN, InN, AlGaN, AlInN, InGaN, AlN, AlInGaN, or a combination thereof. The energy band gap of the barrier layer 136 may be controlled by the composition ratio of Al and/or In. The barrier layer 136 may be doped with a predetermined impurity. In this case, the impurity doped in the barrier layer 136 may be a P-type dopant that can provide holes. For example, the impurity doped in the barrier layer 136 may be magnesium (Mg). A threshold voltage, on-resistance, and the like of the diode unit TU of the semiconductor device may be controlled by increasing or decreasing the impurity doping concentration of the barrier layer 136.

The barrier layer 136 may include a semiconductor material having different characteristics from the channel layer 132. The barrier layer 136 may differ from the channel layer 132 in at least one of a polarization characteristic, an energy band gap, or a lattice constant. For example, the barrier layer 136 may include a material having a different energy band gap than the channel layer 132. In this case, the barrier layer 136 may have a higher energy band gap than the channel layer 132 and may have a higher electric polarization rate than the channel layer 132. 2DEG 134 may be induced in the channel layer 132, which has a relatively low electrical polarization rate, by the barrier layer 136. In this respect, the barrier layer 136 may also be called a channel supply layer or a 2DEG supply layer. The 2DEG 134 may be formed within a portion of the channel layer 132 disposed below an interface between the channel layer 132 and the barrier layer 136. The 2DEG 134 may have a relatively very high electron mobility.

The barrier layer 136 may be composed of a single layer or multiple layers. When the barrier layer 136 is formed of multiple layers, materials of the respective layers that constitute the multiple layers may have different energy band gaps. In this case, the multiple layers constituting the barrier layer 136 may be arranged such that the energy band gap becomes larger the closer a layer is to the channel layer 132.

The gate electrode 155 may be disposed on the barrier layer 136. The gate electrode 155 may overlap with some region of the barrier layer 136 in the third direction (Z direction). The gate electrode 155 may overlap with a part of the drift region DTR of the channel layer 132 in the third direction (Z direction). The gate electrode 155 may be disposed between the source electrode 170 and the drain electrode 190. The gate electrode 155 may be separated from the source electrode 170 and the drain electrode 190. For example, the gate electrode 155 may be positioned closer to the source electrode 170 than to the drain electrode 190. That is, a separation distance between the gate electrode 155 and the source electrode 170 may be smaller than a separation distance between the gate electrode 155 and the drain electrode 190, but the present disclosure is not limited thereto. Here, the third direction (Z direction) may mean a thickness direction of the channel layer 132.

The gate electrode 155 may include a conductive material. For example, the gate electrode 155 may include a metal, a metal alloy, a conductive metal nitride, a metal silicide, a doped semiconductor material, a conductive metal oxide, or a conductive metal nitride. For example, the gate electrode 155 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonized nitride (TiAlC-N), titanium aluminum carbide (TiAlC), titanium carbide (TiC), tantalum carbonized nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof. The gate electrode 155 may be formed of a single layer or multiple layers.

In some implementations, a hard mask layer disposed on the gate electrode 155 may further be included. The hard mask layer may be a hard mask used when patterning the gate electrode material layer or gate semiconductor layer during the process of forming the gate electrode 155. However, the hard mask layer may be removed depending on etch conditions during etching of the gate electrode material layer or gate semiconductor layer or depending on cleaning conditions after etching. For example, the hard mask layer may include silicon oxide, silicon nitride, silicon oxynitride, or a combination thereof.

The gate semiconductor layer 152 may be disposed between the barrier layer 136 and the gate electrode 155. That is, the gate semiconductor layer 152 may be disposed on the barrier layer 136, or the gate electrode 155 may be disposed on the gate semiconductor layer 152. The gate electrode 155 may be in Schottky contact or ohmic contact with the gate semiconductor layer 152. The gate semiconductor layer 152 overlaps the gate electrode 155 in the third direction (Z direction). In this case, the gate semiconductor layer 152 may completely overlap the gate electrode 155 in the third direction (Z direction), and the upper surface of the gate semiconductor layer 152 may be entirely covered by the gate electrode 155. That is, the gate semiconductor layer 152 may have substantially the same planar shape as the gate electrode 155. However, the present disclosure is not limited thereto, the gate electrode 155 may be disposed to cover at least a portion of the gate semiconductor layer 152.

The gate semiconductor layer 152 may be disposed between the source electrode 170 and the drain electrode 190. The gate semiconductor layer 152 may be separated from the source electrode 170 and the drain electrode 190. The gate semiconductor layer 152 may be disposed closer to the source electrode 170 than to the drain electrode 190. That is, a separation distance between the gate semiconductor layer 152 and the source electrode 170 may be smaller than a separation distance between the gate semiconductor layer 152 and the drain electrode 190, but the present disclosure is not limited thereto.

In some implementations, the gate semiconductor layer 152 may overlap the gate electrode 155 in the third direction (Z direction). For example, the gate semiconductor layer 152 may completely overlap the gate electrode 155 in the third direction (Z direction). That is, a side surface of the gate semiconductor layer 152 may be aligned with a side surface of the gate electrode 155. However, the present disclosure is not limited thereto, the gate semiconductor layer 152 may partially overlap the gate electrode 155.

The gate semiconductor layer 152 may include one or more materials selected from group III-V materials, for example, nitrides including Al, Ga, In, B, or a combination thereof. The gate semiconductor layer 152 may be AlₓIn_{y}Ga_{1-x-y}N (0≤x≤1, 0≤y≤1, x+y≤1). For example, the gate semiconductor layer 152 may include AlN, GaN, InN, InGaN, AlGaN, AlInN, AlInGaN, or a combination thereof. The gate semiconductor layer 152 may include a semiconductor material having different characteristics from the barrier layer 136. For example, the gate semiconductor layer 152 may contain GaN, and the barrier layer 136 may contain AlGaN. The gate semiconductor layer 152 may be doped with a predetermined impurity. In this case, the impurity doped in the gate semiconductor layer 152 may be a P-type dopant that can provide holes. For example, the gate semiconductor layer 152 may include GaN doped with P-type impurity. That is, the gate semiconductor layer 152 may be formed of a p-GaN layer. However, the present disclosure is not limited thereto, and the gate semiconductor layer 152 may be a p-AlGaN layer.

A depletion region DPR may be formed within the channel layer 132 by the gate semiconductor layer 152. The depletion region DPR may be disposed in the drift region DTR and may have a narrower width than the drift region DTR. Since the gate semiconductor layer 152, which has a different energy band gap from the barrier layer 136, is disposed on the barrier layer 136, the level of the energy band of the portion of the barrier layer 136 that overlaps the gate semiconductor layer 152 may increase. Accordingly, the depletion region DPR may be formed in a region of the channel layer 132 that overlaps the gate semiconductor layer 152. The depletion region DPR may be a region in the channel path of channel layer 132 where the 2DEG 134 is not formed or has lower electron concentration than the remaining regions. That is, the depletion region DPR may mean a region where the flow of the 2DEG 134 is interrupted within the drift region DTR. As the depletion region DPR is formed, a current does not flow between the source electrode 170 and the drain electrode 190, and the channel path may be blocked. Accordingly, the diode unit TU of the semiconductor device may have a normally off characteristic.

That is, the diode unit TU of the semiconductor device may be a normally-off high electron mobility transistor (HEMT). As shown in FIG. 2, in a normal state where no voltage is applied to the gate electrode 155, the depletion region DPR exists, and the diode unit TU of the semiconductor device may be in the off state. As shown in FIG. 3, when a voltage higher than the threshold voltage is applied to the gate electrode 155, the depletion region DPR disappears, and the 2DEG 134 may be connected without being disconnected within the drift region DTR. That is, the 2DEG 134 may be formed throughout the channel path between the source electrode 170 and the drain electrode 190, and the diode unit TU of the semiconductor device can be turned on. In this case, the threshold voltage of the diode unit TU of the semiconductor device may be 1 V to 1.3 V, but the present disclosure is not limited thereto.

In summary, the diode unit TU of the semiconductor device may include semiconductor layers having different electrical polarization characteristics, and a semiconductor layer having a relatively large polarization ratio may induce a 2DEG 134 in another semiconductor layer heterojunction therewith. The 2DEG 134 may be used as a channel between the source electrode 170 and the drain electrode 190, and the flow of the 2DEG 134 may be continued or interrupted by a bias voltage applied to the gate electrode 155. In the gate off state, the flow of 2DEG 134 is blocked, and thus no current may flow between the source electrode 170 and the drain electrode 190. As the flow of 2DEG 134 continues in the gate on state, a current may flow between the source electrode 170 and the drain electrode 190.

In the above, the diode unit TU of the semiconductor device is described as a normally-off high electron mobility transistor, but the present disclosure is not limited thereto. For example, the diode unit TU of the semiconductor device may be a normally-off HEMT. For the normally-off HEMT, the gate semiconductor layer 152 may be omitted, and thus the gate electrode 155 may be disposed directly above the barrier layer 136. That is, the gate electrode 155 may be in contact with the barrier layer 136. In this structure, the 2DEG 134 may be used as a channel when no voltage is applied to the gate electrode 155, and a current may flow between the source electrode 170 and the drain electrode 190. In addition, when a negative voltage is applied to the gate electrode 155, the depletion region DPR may be formed below the gate electrode 155, where the flow of the 2DEG 134 is cut off.

The seed layer 121, the superlattice layer 124, the high-resistive layer 126, the channel layer 132, the barrier layer 136, and the gate semiconductor layer 152 described above may be sequentially stacked on the substrate 110. In some implementations, in the diode unit TU of the semiconductor device, at least one of the seed layer 121, the superlattice layer 124, the high-resistive layer 126, the channel layer 132, the barrier layer 136, and the gate semiconductor layer 152 may be omitted. The seed layer 121, superlattice layer 124, high-resistive layer 126, channel layer 132, barrier layer 136, and gate semiconductor layer 152 may be formed of the same semiconductor material, and the material composition ratio of each layer may be different considering the role of each layer and the desired performance for the diode unit TU of the semiconductor device.

The diode unit TU of the semiconductor device may further include a first protective layer 140 and a second protective layer 180 sequentially disposed on the barrier layer 136.

The first protective layer 140 may be disposed on the barrier layer 136 and the gate electrode 155. The first protective layer 140 may cover upper and side surfaces of the gate electrode 155 and a side surface of the gate semiconductor layer 152. A bottom surface of the first protective layer 140 may be in contact with the barrier layer 136 and the gate electrode 155. Accordingly, the barrier layer 136, the gate semiconductor layer 152, and the gate electrode 155 may be protected by the first protective layer 140. However, the present disclosure is not limited thereto, and the gate electrode 155 may be connected to the gate semiconductor layer 152 by penetrating the first protective layer 140, and the first protective layer 140 may not cover the upper surface of the gate electrode 155. In some implementations, the bottom surface of the first protective layer 140 may be in contact with the gate semiconductor layer 152. The first protective layer 140 may include an insulating material. For example, the first protective layer 140 may include an oxide such as SiO₂ or Al₂O₃. As another example, the first protective layer 140 may include a nitride such as SiN or an oxynitride such as SiON.

The second protective layer 180 may cover an upper surface of the first protective layer 140, upper and side surfaces of the field disperse layer, and upper surfaces of the source electrode 170 and drain electrode 190. The second protective layer 180 may include an insulating material. The second protective layer 180 may include the same material as the first protective layer 140, but the present disclosure is not limited thereto. For example, the second protective layer 180 may include an oxide such as SiO₂ or Al₂O₃. As another example, the second protective layer 180 may include a nitride such as SiN or an oxynitride such as SiON.

In FIG. 2 and FIG. 3, the first protective layer 140 and the second protective layer 180 are formed of a single layer, but the present disclosure is not limited thereto. The first protective layer 140 and the second protective layer 180 may be formed of multiple layers including different materials.

The source electrode 170 and the drain electrode 190 may be disposed on the channel layer 132. The source electrode 170 and the drain electrode 190 may be directly in contact with the channel layer 132 and may be electrically connected with the channel layer 132.

The source electrode 170 and the drain electrode 190 may be elongated in the second direction (Y direction). The source electrode 170 and the drain electrode 190 may be separated from each other, and the gate electrode 155 and the gate semiconductor layer 152 may be disposed between the source electrode 170 and the drain electrode 190. The gate electrode 155 and the gate semiconductor layer 152 may be separated from the source electrode 170 and the drain electrode 190. For example, the source electrode 170 may be electrically connected to the channel layer 132 on one side of the gate electrode 155, and the drain electrode 190 may be electrically connected to the channel layer 132 on the other side of the gate electrode 155. The source electrode 170 and the drain electrode 190 may be disposed outside the drift region DTR of the channel layer 132. The interface between the source electrode 170 and the channel layer 132 may be one edge of the drift region DTR. Similarly, the interface between the drain electrode 190 and the channel layer 132 may be the other edge of the drift region DTR.

However, the present disclosure is not limited thereto, and the channel layer 132 may not be recessed, and the source electrode 170 and the drain electrode 190 may be disposed on the upper surface of the channel layer 132. In this case, the bottom surfaces of the source electrode 170 and the drain electrode 190 may be in contact with the upper surface of the channel layer 132. A portion of the channel layer 132 in contact with the source electrode 170 and the drain electrode 190 may be doped with a high concentration. In this case, carriers passing through the 2DEG 134 may be transferred to the source electrode 170 and the drain electrode 190 through the portion of channel layer 132 that is doped with high concentration, e.g., the upper portion of the 2DEG 134. The source electrode 170 and the drain electrode 190 may not be in direct contact with the 2DEG 134 in the horizontal direction. Here, the horizontal direction may mean a direction parallel to the upper surface of the channel layer 132 or the barrier layer 136.

Specifically, a trench penetrating the first protective layer 140 and the barrier layer 136 and recessing the upper surface of the channel layer 132 may be disposed so as to be spaced apart from each other on both sides of the gate electrode 155. The source electrode 170 and the drain electrode 190 may be disposed in the trenches on both sides of the gate electrode 155, respectively. The source electrode 170 and the drain electrode 190 may be formed to fill the inside of the trench. Within the trench, the source electrode 170 and the drain electrode 190 may be in contact with the channel layer 132 and the barrier layer 136. The channel layer 132 may form a bottom surface and a sidewall of the trench, and the barrier layer 136 may form a sidewall of the trench. Therefore, the source electrode 170 and the drain electrode 190 may contact the upper surface and the side surface of the channel layer 132. In addition, the source electrode 170 and the drain electrode 190 may be in contact with a side surface of the barrier layer 136. That is, the source electrode 170 and the drain electrode 190 may cover the side surfaces of the channel layer 132 and the barrier layer 136.

In some implementations, the source electrode 170 and the drain electrode 190 may cover at least a part of the side surface of the first protective layer 140. For example, the source electrode 170 and the drain electrode 190 may cover the side surface of the first protective layer 140. The upper surfaces of the source electrode 170 and the drain electrode 190 may protrude relative to the upper surface of the first protective layer 140. In addition, at least one of the source electrode 170 and the drain electrode 190 may cover at least a portion of the upper surface of the first protective layer 140. In some implementations, the source electrode 170 and the drain electrode 190 may cover at least a part of the side surface of the first protective layer 140 and may not cover the remaining portion of the side surface of the first protective layer 140. In this case, the remaining portion of the first protective layer 140 may be disposed on the upper surfaces of the source electrode 170 and the drain electrode 190.

The diode unit TU of the semiconductor device may further include an upper source electrode 175 disposed on the source electrode 170 and an upper drain electrode 195 disposed on the drain electrode 190. Here, the upper source electrode 175 may be configured as a part of a connection wire 210 described later.

The upper source electrode 175 may be disposed on the source electrode 170. The upper source electrode 175 may be formed as a part of the connection wire 210 described later. A portion of connection wire 210 disposed within a source via SV penetrating the second protective layer 180 may serve as the upper source electrode 175. In other words, the upper source electrode 175 may be connected to the source electrode 170 through the second protective layer 180. The upper source electrode 175 may contain the same material as the source electrode 170, but the present disclosure is not limited thereto, and the upper source electrode 175 may contain a different material than the source electrode 170. The upper drain electrode 195 may be disposed on the drain electrode 190. The upper drain electrode 195 may be connected to the drain electrode 190 through the second protective layer 180. The upper drain electrode 195 may contain the same material as the drain electrode 190, but the present disclosure is not limited thereto, and may contain a different material.

The source electrode 170 and the drain electrode 190 may include a conductive material. For example, the source electrode 170 and the drain electrode 190 may include a metal, a metal alloy, conductive metal nitride, metal silicide, a doped semiconductor material, a conductive metal oxide, or conductive metal oxynitride. For example, the source electrode 170 and the drain electrode 190 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbon nitride (TiAlC-N), titanium aluminum carbide (TiAlC), titanium carbide (TiC), tantalum carbon nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but the present disclosure is not limited thereto. The source electrode 170 and the drain electrode 190 may be formed of a single layer or multiple layers. The source electrode 170 and the drain electrode 190 may ohmic-contact the channel layer 132. A region of the channel layer 132, which contacts the source electrode 170 and the drain electrode 190, may be doped with relatively high concentration compared to other regions.

Although the diode unit TU of the semiconductor device in FIG. 2 and FIG. 3 includes the source electrode 170, the upper source electrode 175, the drain electrode 190, and the upper drain electrode 195, the number of source electrodes 170 and the number of drain electrodes 190 are not limited thereto. For example, the source electrode 170 may include two or more source electrodes sequentially stacked in a third direction (Z direction) on the channel layer 132, and the drain electrode 190 may include two or more drain electrodes sequentially stacked in the third direction (Z direction) on the channel layer 132. In this case, the source electrode on the channel layer may also perform the function of the connection wire 210 to be connected to the gate electrode 155.

The connection wire 210 may be disposed on the second protective layer 180. The connection wire 210 may be connected between the source electrode 170 and the gate electrode 155. Specifically, the connection wire 210 may include a portion disposed within a source via SV penetrating the second protective layer 180 above the source electrode 170, a portion disposed within a gate via GV penetrating the second protective layer 180 and the first protective layer 140, and a portion disposed above the second protective layer 180. The connection wire 210 may be disposed within the source via SV and connected to the source electrode 170. The connection wire 210 may completely fill the source via SV. The connection wire 210 may be disposed within the gate via GV and connected to the gate electrode 155. The connection wire 210 may completely fill the gate via GV. The connection wire 210 may overlap the source electrode 170 and the gate electrode 155 in the third direction (Z direction).

Although the connection wire 210 is disposed on the second protective layer 180 in FIG. 2 and FIG. 3, the present disclosure is not limited thereto. For example, the connection wire 210 may be disposed directly above the upper surface of the first protective layer 140 to connect the source electrode 170 and the gate electrode 155. As another example, a protective layer may be further disposed between the connection wire 210 and the second protective layer 180 to connect the source electrode 170 and the gate electrode 155.

The connection wire 210 may include a conductive material. The connection wire 210 may contain the same material as the source electrode 170 and the drain electrode 190, but the present disclosure is not limited thereto. For example, the connection wire 210 may include a metal, a metal alloy, a conductive metal nitride, a metal silicide, a doped semiconductor material, a conductive metal oxide, or a conductive metal nitride.

In some implementations, when a voltage higher than the threshold voltage is applied to the gate electrode 155, the diode unit TU may be turned on. In this case, the threshold voltage of the diode unit TU of the semiconductor device may be 1 V to 1.3 V, but the present disclosure is not limited thereto. In such a range, the depletion region DPR of the normally-off high electron mobility transistor disappears, and the 2DEG 134 may be connected within the drift region DTR.

In some implementations, the source electrode 170 and the gate electrode 155 may be electrically connected through the connection wire 210, and therefore a signal having the same voltage size may be applied to the source electrode 170 and the gate electrode 155. For example, as shown in FIG. 3, the drain electrode 190 may be applied with a first voltage V1, and the source electrode 170 and the gate electrode 155 may be applied with a second voltage V2. In this case, a current may flow in the diode unit TU depending on the value obtained by subtracting the magnitude of the first voltage V1 applied to the drain electrode 190 from the magnitude of the second voltage V2 applied to the source electrode 170 and the gate electrode 155 (V2-V1, referred to as a reference voltage hereinafter) and a threshold voltage Vₜₕ of the diode unit TU.

For example, when the reference voltage is smaller than the threshold voltage Vₜₕ (i.e., V2-V1<Vₜₕ), a voltage smaller than the voltage able to turn on the diode unit TU may be applied to the gate electrode 155. This is a case where a backward voltage is applied to the diode unit TU, and a current may not flow to the diode unit TU.

On the other hand, when the reference voltage is larger than the threshold voltage Vₜₕ (i.e., V2-V1>Vₜₕ), a voltage for turning on the diode unit TU may be applied to the gate electrode 155. In this case, as shown in FIG. 3, the depletion region DPR disappears, and the 2DEG 134 within the drift region DTR is continuous, allowing a current to flow. This is a case where a forward voltage is applied to the diode unit TU, and a current may flow through the diode unit TU. Accordingly, the diode unit TU of the semiconductor device may have diode device characteristics in which a current flows at the forward voltage and no current flows at the backward voltage.

The diode unit TU of the semiconductor device may further include a field disperse layer disposed on the first protective layer 140.

The field disperse layer may be disposed between the gate electrode 155 and the drain electrode 190. The field disperse layer may be disposed between the source electrode 170 and the drain electrode 190. The field disperse layer may be disposed on the first protective layer 140. The field disperse layer may overlap the channel layer 132 in the third direction (Z direction).

The field disperse layer may be formed integrally with the source electrode 170. The field disperse layer may extend from one side of the source electrode 170 and cover the gate electrode 155. The field disperse layer may overlap with the gate electrode 155 in the third direction (Z direction).

The field disperse layer may contain the same material as the source electrode 170. The field disperse layer may be formed simultaneously in the same process as the source electrode 170. However, the present disclosure is not limited thereto, the field disperse layer may be disposed in a different layer from the source electrode 170 and may be formed in a different process.

The field disperse layer may serve to disperse, e.g., dissipate, the electric field concentrated around the gate electrode 155. Specifically, the 2DEG 134 may be disposed with very high concentration in a portion of the channel layer 132 disposed between the gate electrode 155 and the source electrode 170 in the gate-off state and in a portion of the channel layer 132 disposed between the gate electrode 155 and the drain electrode 190. In this case, the electric field may be concentrated in the gate electrode 155 or the gate semiconductor layer 152. Meanwhile, the gate electrode 155 and the gate semiconductor layer 152 are vulnerable to electric fields, and when the electric field is concentrated, the leakage current may increase and the breakdown voltage of the diode unit TU may decrease. In this case, the electric field concentrated around the gate electrode 155 or the gate semiconductor layer 152 is dispersed by the field disperse layer, and thus the leakage current may be reduced and the breakdown voltage may be increased.

In some implementations, the number of field disperse layers is not limited thereto. For example, the field disperse layer may include a plurality of field disperse layers disposed on the first protective layer 140. As another example, the field disperse layer may further be disposed on the second protective layer 180.

Hereinafter, the semiconductor device will be described further referring to FIG. 4.

Further referring to FIG. 4, the semiconductor device includes a plurality of diode elements disposed on the substrate 110. Each of the plurality of diode elements may be formed of the diode unit TU (refer to FIG. 2) of the example of FIG. 2 and FIG. 3.

In some implementations, the semiconductor device may include a plurality of backward diodes BT and at least one forward diode FT disposed on the substrate 110. For example, as shown in FIG. 4, the plurality of backward diodes BT may include first backward diode BT1 to the third backward diode BT3 and the at least one forward diode FT may include a first forward diode FT1. In some implementations, each of the plurality of backward diodes BT and the at least one forward diode FT may be formed of the diode unit TU (refer to FIG. 2) of the example of FIG. 2 and FIG. 3.

In this case, a threshold voltage of the plurality of backward diodes BT and a threshold voltage of the at least one forward diode FT may be the same. For example, the threshold voltage of each of the plurality of backward diodes BT and at least one forward diode FT may be 1 V to 1.3 V, but the present disclosure is not limited thereto. In this range, the depletion region DPR of the normally-off high electron mobility transistor may disappear, and the 2DEG 134 may be connected within the drift region DTR.

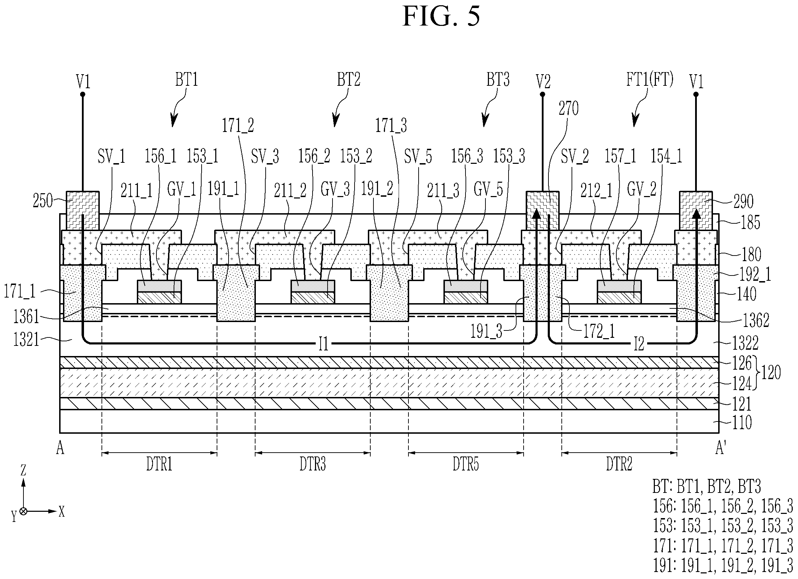

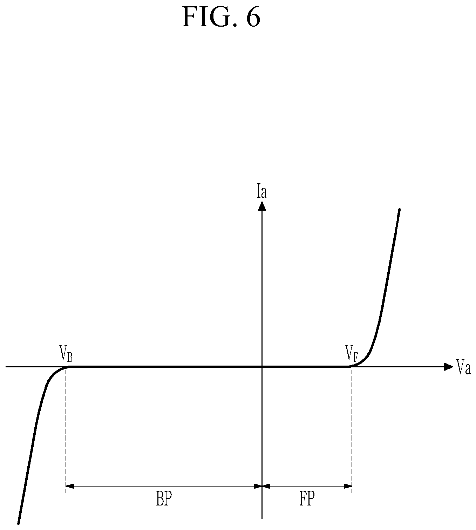

In some implementations, the plurality of backward diodes BT may be connected to each other. The plurality of backward diodes BT may be coupled in series. For example, the first backward diode BT1 may be electrically connected with a second backward diode BT2, and the second backward diode BT2 can be electrically connected to the third backward diode BT3. In addition, the at least one forward diode FT may be connected with any one of the plurality of backward diodes BT. For example, the first forward diode FT1 may be electrically connected with the third backward diode BT3. Accordingly, a plurality of backward diodes BT and at least one forward diode FT may be connected to each other to operate in reverse, and thus perform the Zener diode function. A description of an operation method of the plurality of backward diodes BT and at least one forward diode FT will be described later with reference to FIG. 5 and FIG. 6.

The semiconductor device may further include first to third electrodes 250, 270, and 290, which are connected to the plurality of backward diodes BT and at least one forward diode FT.

The first to third electrodes 250, 270, and 290 may be disposed on the substrate 110. The first to third electrodes 250, 270, and 290 may be disposed apart from each other. The first to third electrodes 250, 270, and 290 may extend in one or more directions. For example, the first to third electrodes 250, 270, and 290 may extend in the second direction (Y direction), but the present disclosure is not limited thereto. The first to third electrodes 250, 270, and 290 may be disposed on the same layer. For example, the first to third electrodes 250, 270, and 290 may be disposed on upper surfaces of first connection wires 21 1_1, 21 1_2, and 211_3 and an upper surface of a second connection wire 212_1. In some implementations, the third electrode 290 may be electrically connected with the first electrode 250. For example, the third electrode 290 may be an electrode that applies the same signal as the first electrode 250, but the present disclosure is not limited thereto.

The first to third electrodes 250, 270, and 290 may be electrically connected to each other by the plurality of backward diodes BT and/or the at least one forward diode FT. For example, the plurality of backward diodes BT may connect the first electrode 250 and the second electrode 270, and the at least one forward diode FT may connect the second electrode 270 and the third electrode 290. In addition, in some implementations, the third electrode 290 may be electrically connected with the first electrode 250 through external wiring. Signals having the same voltage may be applied to the third electrode 290 and the first electrode 250, but the present disclosure is not limited thereto. Hereinafter, for better understanding and ease of description, a diode unit connecting the first electrode 250 and the second electrode 270 may be referred to as a plurality of backward diodes BT, and a diode unit connecting the second electrode 270 and the third electrode 290 may be referred to as a forward diode FT.

Each of the plurality of backward diodes BT of the semiconductor device may include a first channel layer 1321 disposed on the substrate 110, a first barrier layer 1361 disposed on the first channel layer 1321 and having an energy band gap that is different from that of the first channel layer 1321, a first gate electrode 156 disposed on the first barrier layer 1361, a first gate semiconductor layer 153 disposed between the first barrier layer 1361 and the first gate electrode 156, a first source electrode 171 and a first drain electrode 191 disposed at opposite sides of the first gate electrode 156 and connected to the first channel layer 1321, and first connection wires 211_1, 211_2, and 211_3 connecting the first source electrode 171 and the first gate electrode 156.

In addition, each of the at least one forward diode FT of the semiconductor device may include a second channel layer 1322 disposed on the substrate 110, a second barrier layer 1362 disposed on the second channel layer 1322 and having an energy band gap that is different from that of the second channel layer 1322, a second gate electrode 157_1 disposed on the second barrier layer 1362, a second gate semiconductor layer 154_1 that is disposed between the second barrier layer 1362 and the second gate electrode 157_1, a second source electrode 172_1 and a second drain electrode 192_1 disposed at opposite sides of the second gate electrode 157_1 and connected to the second channel layer 1322, and a second connection wire 212_1 connecting the second source electrode 172_1 and the second gate electrode 157_1.

In some implementations, components of the plurality of backward diodes BT and at least one forward diode FT may correspond to components of the diode unit TU of the examples of FIG. 2 and FIG. 3. The components of the plurality of backward diodes BT and the components of the at least one forward diode FT may be formed simultaneously in the same process.

In detail, the first channel layer 1321 and the second channel layer 1322 may correspond to the channel layer (refer to first channel layer 132 in FIG. 2) of the example of FIG. 2. The first channel layer 1321 may be integrally formed with the second channel layer 1322. That is, the first channel layer 1321 may be integrally formed with the second channel layer 1322 through the same process. The first channel layer 1321 may include the same material as the second channel layer 1322 and may be disposed on the same layer. For example, a bottom surface of the first channel layer 1321 may be disposed at the same level as a bottom surface of the second channel layer 1322, and an upper surface of the first channel layer 1321 may be disposed at the same level as the upper surface of the second channel layer 1322. That is, the bottom surface of the first channel layer 1321 may be disposed at the same distance from the bottom surface of the second channel layer 1322 and the upper surface of the substrate 110. A thickness of the first channel layer 1321 along the third direction (Z direction) may be substantially the same as a thickness of the second channel layer 1322 along the third direction (Z direction), but the present disclosure is not limited thereto.

The first barrier layer 1361 and the second barrier layer 1362 may correspond to the barrier layer (refer to 136 of FIG. 2) of the example of FIG. 2. The first barrier layer 1361 may be integrally formed with the second barrier layer 1362. That is, the first barrier layer 1361 may be integrally formed with the second barrier layer 1362 through the same process. The first barrier layer 1361 may include the same material as the second barrier layer 1362 and may be disposed on the same layer as the second barrier layer 1362. For example, a bottom surface of the first barrier layer 1361 may be disposed at the same level as a bottom surface of the second barrier layer 1362, and an upper surface of the first barrier layer 1361 may be disposed at the same level as an upper surface of the second barrier layer 1362. That is, the bottom surface of the first barrier layer 1361 may be disposed at the same distance from the bottom surface of the second barrier layer 1362 and the upper surface of the substrate 110. A thickness of the first barrier layer 1361 along the third direction (Z direction) may be substantially the same as a thickness of the second barrier layer 1362 along the third direction (Z direction), but the present disclosure is not limited thereto.

Accordingly, a drift region may be formed within the first channel layer 1321 that overlaps the first barrier layer 1361 between the first source electrode 171 and the first drain electrode 191 of each of the plurality of backward diodes BT. For example, the first backward diode BT1 may include a first drift region DTR1 disposed between the first source electrode 171_1 and the first drain electrode 191_1, the second backward diode BT2 may include a third drift region DTR3 disposed between the first source electrode 171_2 and the first drain electrode 191_2, and the third backward diode BT3 may include a fifth drift region DTR5 disposed between the first source electrode 171_3 and the first drain electrode 191_3.

In addition, a drift region may be formed within the second channel layer 1322 that overlaps the second barrier layer 1362 between the second source electrode 172_1 and the second drain electrode 192_1 of at least one forward diode FT. For example, the first forward diode FT1 may include a second drift region DTR2 disposed between the second source electrode 172_1 and the second drain electrode 192_1.

The first gate electrode 156 and the second gate electrode 157_1 may correspond to the gate electrode 155 of the example shown in FIG. 2. The first gate electrode 156 may include the same material as the second gate electrode 157_1 and may be disposed on the same layer as the second gate electrode 157_1. For example, a bottom surface of the first gate electrode 156 may be disposed at the same level as a bottom surface of the second gate electrode 157_1, and an upper surface of the first gate electrode 156 may be disposed at the same level as an upper surface of the second gate electrode 157_1, but the present disclosure is not limited thereto.

The first gate semiconductor layer 153 and the second gate semiconductor layer 154_1 may correspond to the gate semiconductor layer 152 of FIG. 2. The first gate semiconductor layer 153 may contain the same material as the second gate semiconductor layer 154_1 and may be disposed in the same layer. For example, the bottom surface of the first gate semiconductor layer 153 may be disposed at the same level as the bottom surface of the second gate semiconductor layer 154_1, and the upper surface of the first gate semiconductor layer 153 may be disposed at the same level as the upper surface of the second gate semiconductor layer 154_1, but the present disclosure is not limited thereto.

The first source electrode 171 and the second source electrode 172_1 may correspond to the source electrode 170 of the example of FIG. 2. The first source electrode 171 contains the same material as the second source electrode 172_1 and may be disposed in the same layer. For example, the bottom surface of the first source electrode 171 may be disposed at the same level as the bottom surface of the second source electrode 172_1, and the upper surface of the first source electrode 171 may be disposed at the same level as the upper surface of the second source electrode 172_1, but the present disclosure is not limited thereto.

The first drain electrode 191 and the second drain electrode 192_1 may correspond to the drain electrode 190 of the example of FIG. 2. The first drain electrode 191 contains the same material as the second drain electrode 192_1 and may be disposed in the same layer. For example, the bottom surface of the first drain electrode 191 may be disposed at the same level as the bottom surface of the second drain electrode 192_1, and the upper surface of the first drain electrode 191 may be disposed at the same level as the upper surface of the second drain electrode 192_1, but the present disclosure is not limited thereto.

The first connection wires 211_1, 211_2, and 211_3 and the second connection wire 212_1 may correspond to the connection wire 210 of the example of FIG. 2. The first connection wires 211_1, 211_2, and 211_3 and the second connection wire 212_1 may be disposed on the second protective layer 180. The first connection wires 211_1, 211_2, and 211_3 may contain the same material as the second connection wire 212_1 and may be disposed in the same layer. For example, the bottom surfaces of the first connection wires 211_1, 211_2, and 211_3 may be disposed at the same level as the bottom surface of the second connection wire 212_1, and the upper surfaces of the first connection wires 211_1, 211_2, and 211_3 may be disposed at the same level as the upper surface of the second connection wire 212_1, but the present disclosure is not limited thereto.

The description of components of the plurality of backward diodes BT and at least one forward diode FT may be applied mostly identically or similarly to the description of components of the corresponding diode unit TU. In the following, duplicate descriptions are omitted and the differences are mainly explained.

In some implementations, the plurality of backward diodes BT and the at least one forward diode FT may be arranged along one direction. Widths of the plurality of backward diodes BT and at least one forward diode FT along the first direction (X direction) can be the same, but the present disclosure is not limited thereto. For example, the first backward diode BT1, the second backward diode BT2, the third backward diode BT3, and the first forward diode FT1 may be sequentially disposed along the first direction (X direction). The first backward diode BT1, the second backward diode BT2, the third backward diode BT3, and the first forward diode FT1 may extend in the second direction (Y direction), but the present disclosure is not limited thereto.

Accordingly, the first gate electrode 156 and the second gate electrode 157_1 may extend in the same direction. For example, the first gate electrode 156_1 of the first backward diode BT1, the first gate electrode 156_2 of the second backward diode BT2, the first gate electrode 156_3 of the third backward diode BT3, and the second gate electrode 157_1 of the first forward diode FT1 may extend in the second direction (Y direction). The first gate electrode 156 and the second gate electrode 157_1 may be disposed apart from each other. The first gate electrode 156_1 of the first backward diode BT1, the first gate electrode 156_2 of the second backward diode BT2, the first gate electrode 156_3 of the third backward diode BT3, and the second gate electrode 157_1 of the first forward diode FT1 may sequentially extend in the first direction (X direction). Widths of the first gate electrode 156_1 of the first backward diode BT1, the first gate electrode 156_2 of the second backward diode BT2, the first gate electrode 156_3 of the third backward diode BT3, and the second gate electrode 157_1 of the first forward diode FT1 in the first direction (X direction) may be the same, but the present disclosure is not limited thereto. A gap between the first gate electrode 156_1 of the first backward diode BT1 and the first gate electrode 156_2 of the second backward diode BT2, a gap between the first gate electrode 156_2 of the second backward diode BT2 and the first gate electrode 156_3 of the third backward diode BT3, and a gap between the first gate electrode 156_3 of the third backward diode BT3 and the second gate electrode 157_1 of the first forward diode FT1 may be the same, but the present disclosure is not limited thereto.

In addition, the first source electrode 171 and the second source electrode 172_1 may extend in the same direction. For example, the first source electrode 171_1 of the first backward diode BT1, the first source electrode 171_2 of the second backward diode BT2, the first source electrode 171_3 of the third backward diode BT3, and the second source electrode 172_1 of the first forward diode FT1 may extend along the second direction (Y direction). The first source electrode 171 and the second source electrode 172_1 may be disposed apart from each other. The first source electrode 171_1 of the first backward diode BT1, the first source electrode 171_2 of the second backward diode BT2, the first source electrode 171_3 of the third backward diode BT3, and the second source electrode 172_1 of the first forward diode FT1 may extend sequentially in the first direction (X direction). In this case, widths of the first source electrode 171_1 of the first backward diode BT1, the first source electrode 171_2 of the second backward diode BT2, the first source electrode 171_3 of the third backward diode BT3, and the second source electrode 172_1 of the first forward diode FT1 in the first direction (X direction) may be the same, but the present disclosure is not limited thereto. In addition, the first drain electrode 191 and the second drain electrode 192_1 may extend in the same direction.

In some implementations, first source vias SV_1, SV_3, and SV_5 and a second source via SV_2 may penetrate the second protective layer 180. The first source vias SV_1, SV_3, and SV_5 may be disposed on the first source electrode 171, and the first connection wires 211_1, 211_2, and 211_3 may be disposed in the first source vias SV_1, SV_3, and SV_5. The second source via SV_2 may be disposed on the second source electrode 172_1, and the second connection wire 212_1 may be disposed in the second source via SV_2. In some implementations, the first source vias SV_1, SV_3, and SV_5 and the second source via SV_2 may extend in the second direction (Y direction). In this case, lengths of the first source vias SV_1, SV_3, and SV_5 and the second source via SV_2 in the second direction (Y direction) may be substantially the same as the lengths of the first source electrode 171 and the second source electrode 172_1 in the second direction (Y direction), but the present disclosure is not limited thereto.

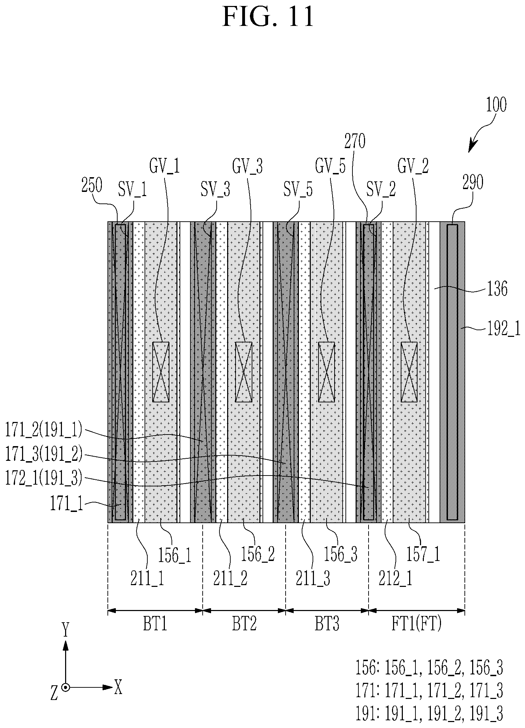

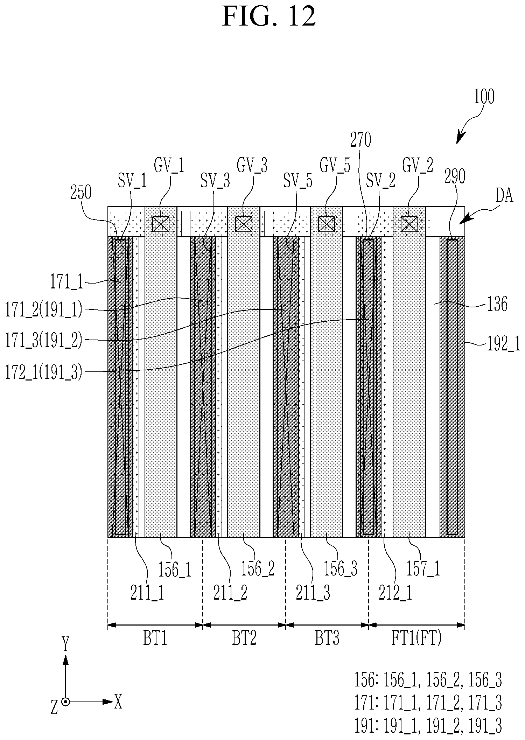

First gate vias GV_1, GV_3, and GV_5 and a second gate via GV_2 may penetrate the second protective layer 180 and the first protective layer 140. The first gate vias GV_1, GV_3, and GV_5 may be disposed on the first gate electrode 156, and the first connection wires 211_1, 211_2, and 211_3 may be disposed within the first gate vias GV_1, GV_3, and GV_5. The second gate via GV_2 may be disposed on the second gate electrode 157_1, and the second connection wire 212_1 may be disposed in the second gate via GV_2. The first gate vias GV_1, GV_3, and GV_5 and the second gate via GV_2 may extend in the second direction (Y direction). In this case, lengths of the first gate vias GV_1, GV_3, and GV_5 and the second gate via GV_2 in the second direction (Y direction) may be almost similar to the lengths of the first gate electrode 156 and the second gate electrode 157_1 in the second direction (Y direction), but the present disclosure is not limited thereto. Descriptions related to this will be described later with reference to FIG. 11 and FIG. 12.

In some implementations, the plurality of backward diodes BT may be connected to each other. The plurality of backward diodes BT may be coupled in series. For example, the first drain electrode 191_1 of the first backward diode BT1 may be electrically connected with the first source electrode 171_2 of the second backward diode BT2, and the first drain electrode 191_2 of the second backward diode BT2 may be electrically connected with the first source electrode 171_3 of the third backward diode BT3. In this case, the first drain electrode 191_1 of the first backward diode BT1 and the first source electrode 171_2 of the second backward diode BT2 may be integrally formed. That is, the first drain electrode 191_1 of the first backward diode BT1 and the first source electrode 171_2 of the second backward diode BT2 may be integrally formed in the same process. Accordingly, the first drain electrode 191_1 of the first backward diode BT1 and the first source electrode 171_2 of the second backward diode BT2 may include the same material and may be disposed in the same layer.

In addition, the first drain electrode 191_2 of the second backward diode BT2 and the first source electrode 171_3 of the third backward diode BT3 may be integrally formed. That is, the first drain electrode 191_2 of the second backward diode BT2 and the first source electrode 171_3 of the third backward diode BT3 may be integrally formed in the same process. Accordingly, the first drain electrode 191_2 of the second backward diode BT2 and the first source electrode 171_3 of the third backward diode BT3 may contain the same material and may be disposed in the same layer.

In some implementations, one of the plurality of backward diodes BT may be connected with at least one forward diode FT. For example, as shown in FIG. 4, the first drain electrode 191_3 of the third backward diode BT3 and the second source electrode 172_1 of the first forward diode FT1 may be electrically connected with each other. In this case, the first drain electrode 191_3 of the third backward diode BT3 and the second source electrode 172_1 of the first forward diode FT1 may be integrally formed. That is, the first drain electrode 191_3 of the third backward diode BT3 and the second source electrode 172_1 of the first forward diode FT1 may be integrally formed in the same process. Accordingly, the first drain electrode 191_3 of the third backward diode BT3 and the second source electrode 172_1 of the first forward diode FT1 may contain the same material and may be disposed in the same layer.

Accordingly, one of the first connection wires 211_1, 211_2, and 211_3 of the plurality of backward diodes BT may be electrically connected with a first drain electrode 191 of another one of the plurality of backward diodes BT. For example, the first connection wire 211_2 of the second backward diode BT2 may be connected with the first drain electrode 191_1 of the first backward diode BT1. The first connection wire 211_2 of the second backward diode BT2 may be disposed on the first source via SV_3 penetrating the first protective layer 140 and may be disposed on the first drain electrode 191_1 of the first backward diode BT1. The first connection wire 211_2 of the second backward diode BT2 may overlap the first drain electrode 191_1 of the first backward diode BT1 in the third direction (Z direction). The first connection wire 211_2 of the second backward diode BT2 may be in contact with an upper surface of the first drain electrode 191_1 of the first backward diode BT1, but the present disclosure is not limited thereto.

In addition, the first connection wire 211_3 of the third backward diode BT3 may be connected with the first drain electrode 191_2 of the second backward diode BT2. The first connection wire 211_3 of the third backward diode BT3 may be disposed on the first source via SV_5 penetrating the first protective layer 140 and may be disposed on the first drain electrode 191_2 of the second backward diode BT2. The first connection wire 211_3 of the third backward diode BT3 may overlap the first drain electrode 191_2 of the second backward diode BT2 in the third direction (Z direction). The first connection wire 211_3 of the third backward diode BT3 may be in contact with an upper surface of the first drain electrode 191_2 of the second backward diode BT2, but the present disclosure is not limited thereto.

In addition, a second connection wire 212_1 of any forward diode FT may be connected to the first drain electrode 191 of any one of the plurality of backward diodes BT. For example, the second connection wire 212_1 of the first forward diode FT1 may be connected with the first drain electrode 191_3 of the third backward diode BT3. The second connection wire 212_1 of the first forward diode FT1 may be disposed on the second source via SV_2 penetrating the first protective layer 140 and may be disposed on the first drain electrode 191_3 of the third backward diode BT3. The second connection wire 212_1 of the first forward diode FT1 may overlap the first drain electrode 191_3 of the third backward diode BT3 in the third direction (Z direction). The second connection wire 212_1 of the first forward diode FT1 may be in contact with an upper surface of the first drain electrode 191_3 of the third backward diode BT3, but the present disclosure is not limited thereto.

In some implementations, the first to third electrodes 250, 270, and 290 may be electrically connected to the plurality of backward diodes BT and/or at least one forward diode FT.

For example, the first electrode 250 may be electrically connected with the first connection wire 211_1 of the first backward diode BT1. Accordingly, the first electrode 250 may be electrically connected with the first source electrode 171_1 of the first backward diode BT1 through the first connection wire 211_1. The first electrode 250 may be in contact with an upper surface of the first connection wire 211_1 of the first backward diode BT1, but the present disclosure is not limited thereto. The second electrode 270 may be electrically connected to the second connection wire 212_1 of the first forward diode FT1. Accordingly, the second electrode 270 may be electrically connected with the first drain electrode 191_3 of the third backward diode BT3 and the second source electrode 172_1 of the first forward diode FT1 through the second connection wire 212_1. The second electrode 270 may be in contact with an upper surface of the second connection wire 212_1 of the first forward diode FT1, but the present disclosure is not limited thereto. The third electrode 290 may be electrically connected with the second drain electrode 192_1 of the first forward diode FT1.

Meanwhile, the third electrode 290 may be electrically connected with the first electrode 250. Accordingly, the second drain electrode 192_1 of the first forward diode FT1 may be electrically connected with the first source electrode 171_1 of the first backward diode BT1 through the third electrode 290 and the first electrode 250. The same signal may be applied to the second drain electrode 192_1 of the first forward diode FT1 and the first source electrode 171_1 of the first backward diode BT1. In other words, the second source electrode 172_1 of the first forward diode FT1 may be electrically connected to a first drain electrode 191 of one of the backward diodes BT, and the second drain electrode 192_1 may be electrically connected to a first source electrode 171 of the other backward diode BT.

In some implementations, the plurality of backward diodes BT of the semiconductor device 100 are coupled in series with each other, and thus the threshold voltage of the entire plurality of backward diodes BT may be the sum of the threshold voltage of each of the connected backward diodes. For example, as in the example of FIG. 4, the threshold voltage of the entire first backward diode BT1 to the third backward diode BT3 may be the sum of the threshold voltage of each of the first backward diode BT1 to the third backward diode BT3. Meanwhile, each of the plurality of backward diodes BT may have substantially the same threshold voltage. Therefore, the threshold voltages of the entire first backward diode BT1 to the third backward diode BT3 may be substantially the same as the product of the threshold voltage of any one backward diode times the number of backward diodes coupled in series. In addition, each of the plurality of backward diodes BT may have a threshold voltage of substantially the same size as at least one forward diode FT. For example, the threshold voltage of each of the plurality of backward diodes BT and at least one forward diode FT may be 1 V to 1.3 V.

Hereinafter, for better understanding and ease of explanation, the threshold voltage of at least one forward diode FT is referred to as a first threshold voltage (V_{F} in FIG. 6), and the threshold voltage of the entire plurality of backward diodes BT is referred to as a second threshold voltage (V_{B} in FIG. 6). For example, the magnitude of the first threshold voltage (V_{F} in FIG. 6) may be 1 V to 1.3 V, and the magnitude of the second threshold voltage (V_{B} in FIG. 6) may be 3 V to 3.9 V, but the present disclosure is not limited thereto.

Although the first source electrode 171 and the first drain electrode 191 are integrally formed, and the first drain electrode 191 and the second source electrode 172_1 are integrally formed in FIG. 4, the present disclosure is not limited thereto. The first source electrode 171 and the first drain electrode 191 may be separate components from each other, and/or the first drain electrode 191 and the second source electrode 172_1 may be separate components from each other. In this case, the first source electrode 171 and the first drain electrode 191 may be connected by one or more other components, and the first drain electrode 191 and the second source electrode 172_1 may be connected by one or more other components.

In FIG. 4, the first to third electrodes 250, 270, and 290 are connected to the source electrode and the drain electrode through the first and second connection wires 211_1, 211_2, 211_3, 212_1, but the present disclosure is not limited thereto. For example, the first to third electrodes 250, 270, and 290 may directly contact the source electrode and the drain electrode. As another example, the first to third electrodes 250, 270, and 290 may be electrically connected to the source electrode and drain electrode via wires disposed above the first and second connection wires 212_1.

In FIG. 4, the semiconductor device includes three backward diodes BT and one forward diode FT, but the number of backward diodes BT and forward diode FT is not limited thereto. For example, the semiconductor device may include two or more backward diodes BT and one or more forward diodes FT.

The semiconductor device may further include a capping layer 185 disposed on the first connection wires 211_1, 211_2, and 211_3 and the second connection wire 212_1.

The capping layer 185 may cover the first connection wires 211_1, 211_2, and 211_3 and the second connection wire 212_1. The capping layer 185 may be disposed on the second protective layer 180. The first to third electrodes 250, 270, and 290 may be connected to the first connection wires 211_1, 211_2, and 211_3 or the second connection wire 212_1 through the capping layer 185. The capping layer 185 may include an insulating material. The capping layer 185 may include the same material as the first protective layer 140 and the second protective layer 180, but the present disclosure is not limited thereto. For example, the capping layer 185 may contain an oxide such as SiO₂ or Al₂O₃. As another example, the capping layer 185 may include a nitride such as SiN or an oxynitride such as SiON.

Hereinafter, a driving method of the semiconductor device will be described with further reference to FIG. 5 and FIG. 6.

FIG. 5 is a cross-sectional view of an example of the flow of the current of the semiconductor device corresponding to the line A-A' of FIG. 1. FIG. 6 is a graph of the change in current intensity of the semiconductor device versus a difference in voltages applied to the semiconductor device.

Hereinafter, as in the example of FIG. 4 and FIG. 5, a case where the semiconductor device includes three backward diodes and one forward diode will be described.

Referring to FIG. 5 and FIG. 6, the first electrode 250 and the third electrode 290 of the semiconductor device may be applied with a first voltage V1, and the second electrode 270 may be applied with a second voltage V2. In some implementations, the third electrode 290 may be electrically connected with the first electrode 250.

In some implementations, the first drain electrode 191 of the plurality of backward diodes BT may be electrically connected with the second electrode 270, and the second source electrode 172_1 of the at least one forward diode FT may be electrically connected with the second electrode 270. That is, the voltages applied to the first source electrode 171 and the first drain electrode 191 of the backward diodes BT may be opposite to the voltages applied to the second source electrode 172_1 and the second drain electrode 192_1 of the forward diode FT. Accordingly, the plurality of backward diodes BT and at least one forward diode FT may operate in the opposite way.

Hereinafter, for better understanding and ease of description, a value (V2-V1) obtained by subtracting the magnitude of the first voltage V1 applied to the second drain electrode 192_1 of the first forward diode FT1 from the magnitude of the second voltage V2 applied to the second source electrode 172_1 of the first forward diode FT1 is referred to as a reference voltage Va. Meanwhile, since the plurality of backward diodes BT and at least one forward diode FT operate in opposite way, the second threshold voltage V_{B} may have a negative value with respect to the reference voltage Va. For example, the first threshold voltage V_{F} may be 1 V to 1.3 V, and the second threshold voltage V_{B} may be -3 V to -3.9 V, but the present disclosure is not limited thereto.

In some implementations, when the reference voltage Va is greater than the first threshold voltage VF (V2-V1 > V_{F}), the forward diode FT may be turned on. Accordingly, the current may flow from the second electrode 270 through the second source electrode 172_1 and the second drain electrode 192_1 to the third electrode 290 along a second path I2. In this case, since the reference voltage Va is greater than the second threshold voltage V_{B}, the backward diodes BT may not operate.

In addition, when the reference voltage Va is between the first threshold voltage V_{F} and the second threshold voltage V_{B} (V_{B} < (V2-V1) < V_{F}), the backward diodes BT may be turned off because the reference voltage Va is greater than the second threshold voltage V_{B}, and the forward diode FT may be turned off because the reference voltage Va is less than the first threshold voltage V_{F}. In this case, no current may flow within the semiconductor device 100 during a first voltage section BP and a second voltage section FP.

Meanwhile, when the reference voltage Va is smaller than the second threshold voltage V_{B} (i.e., V2-V1<V_{B}), the backward diodes BT may be turned on. Accordingly, the current may flow from the first electrode 250 through the first source electrode 171_1 and first drain electrode 191_3 to the second electrode 270 along a first path I1. In this case, as shown in FIG. 6, even if the magnitude of the current flowing along the first path I1 increases, the reference voltage Va may be maintained at a value similar to the second threshold voltage V_{B}. In this case, the forward diode FT may be turned off, and the current may not flow along the second path I2.

In summary, in some implementations, the semiconductor device 100 may allow the current to flow from the second electrode 270 to the third electrode 290 along the second path I2 when a forward voltage (e.g., when the reference voltage Va is greater than the first threshold voltage V_{F}, V2-V1 > V_{F}) is applied, and when a backward voltage (e.g., when the reference voltage Va is less than the first threshold voltage V_{F}) and greater than the second threshold voltage V_{B}), V_{B} < (V2-V1) <V_{F}) is applied, the current may not flow.

Meanwhile, in some implementations, the semiconductor device 100 may allow the current to flow from the first electrode 250 to the second electrode 270 along the first path I1 when a backward voltage greater than a predetermined magnitude is applied. Accordingly, the semiconductor device 100 may serve as a Zener diode having the second threshold voltage V_{B} as a breakdown voltage. Accordingly, even when a backward voltage greater than a predetermined magnitude is applied between the first electrode 250 and the second electrode 270, the voltage between the first electrode 250 and the second electrode 270 may be maintained at a voltage similar to the second threshold voltage V_{B}.

In some implementations of the semiconductor device 100, the backward diodes BT and the forward diode FT are configured using the diode units (TU of FIG. 2), and therefore a Zener diode having a desired breakdown voltage can be easily designed.

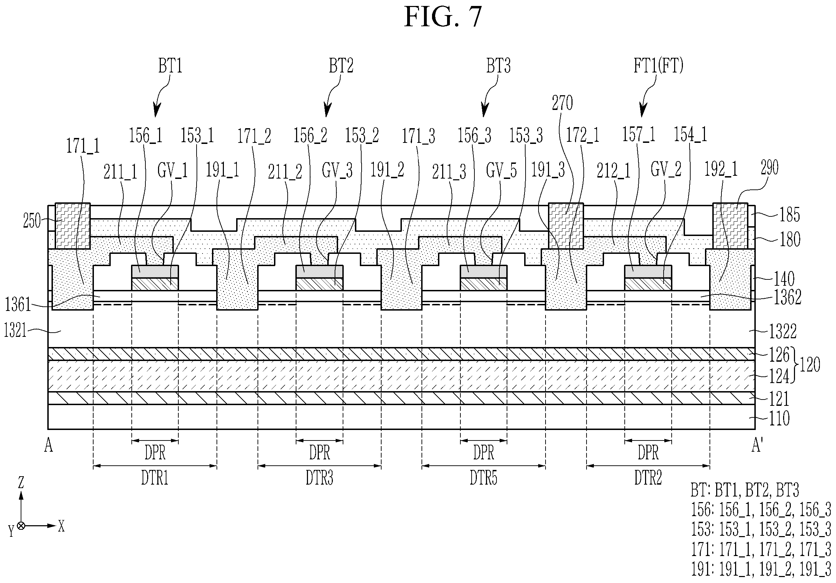

Hereinafter, a semiconductor device according to some examples will be described with reference to FIG. 7 to FIG. 14.

FIG. 7 to FIG. 10 are cross-sectional views of an example of a semiconductor device, taken along the line A-A' of FIG. 1. FIG. 11 to FIG. 14 are top plan views of an example of a semiconductor device.

FIG. 7 to FIG. 14 show numerous variations of the semiconductor device shown in FIG. 1 to FIG. 6. Examples illustrated in FIG. 7 to FIG. 14 are substantially the same as the examples illustrated in FIG. 1 to FIG. 6, and therefore repeated description thereof will be omitted and the differences will be mainly explained. In addition, the same reference numerals are used for the same components as in the previous example.

Referring to FIG. 7, first connection wires 211_1, 211_2, and 211_3 of a semiconductor device according to some example may be integrally formed with a first source electrode 171, and a second connection wire 212_1 may be integrally formed with a second source electrode 172_1.

In some examples, the first connection wires 211_1, 211_2, and 211_3 may be disposed between the first protective layer 140 and the second protective layer 180. The first connection wires 211_1, 211_2, and 211_3 may be integrally formed with the first source electrode 171. For example, the first connection wires 211_1, 211_2, and 211_3 may be formed together in the same process as the first source electrode 171. The first connection wires 211_1, 211_2, and 211_3 may include the same material as the first source electrode 171. The first connection wires 211_1, 211_2, and 211_3 may be connected to the first gate electrode 156 through first gate vias GV_1, GV_3, and GV_5 penetrating the first protective layer 140. The first connection wires 211_1, 211_2, and 211_3 may be in contact with an upper surface of the first gate electrode 156, but the present disclosure is not limited thereto.

In some examples, the second connection wire 212_1 may be disposed between the first protective layer 140 and the second protective layer 180. The second connection wire 212_1 may be integrally formed with the second source electrode 172_1. For example, the second connection wire 212_1 may be formed together with the second source electrode 172_1 in the same process. The second connection wire 212_1 may include the same material as the second source electrode 172_1. The second connection wire 212_1 may be connected to the second gate electrode 157_1 through a second gate via GV_2 penetrating the first protective layer 140. The second connection wire 212_1 may be in contact with an upper surface of the second gate electrode 157_1, but the present disclosure is not limited thereto.

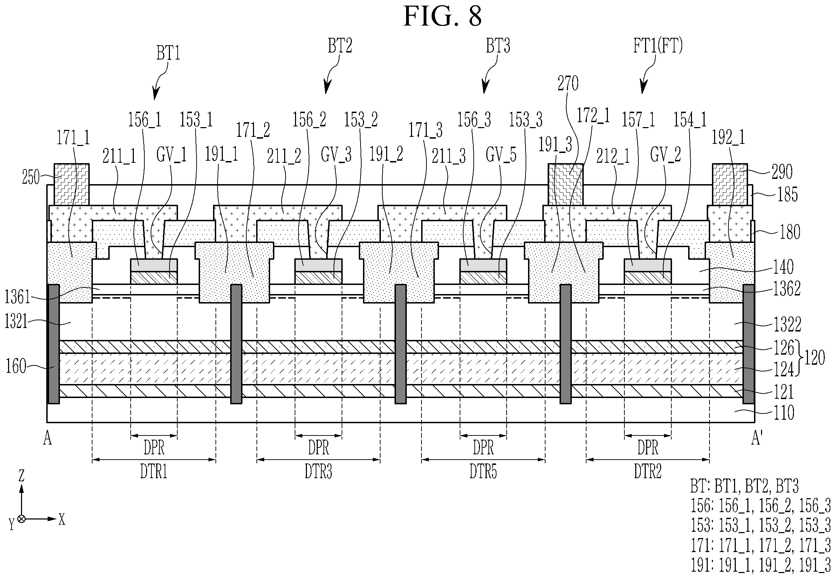

Referring to FIG. 8, the semiconductor device may further include a separation structure 160 penetrating barrier layers 1361 and 1362 and channel layers 1321 and 1322.

For example, the separation structure 160 may recess at least a part of a substrate 110 by penetrating the barrier layers 1361 and 1362, the channel layers 1321 and 1322, a seed layer 121, and a buffer layer 120. First channel layers 1321 of each backward diode BT may be separated from each other. As another example, the separation structure 160 may penetrate only the barrier layers 1361 and 1362 and disposed on the channel layers 1321 and 1322. As another example, the separation structure 160 may penetrate only the barrier layers 1361 and 1362 and the channel layers 1321 and 1322. As another example, the separation structure 160 may penetrate the barrier layers 1361 and 1362 and the channel layers 1321 and 1322, and recess at least a portion of the buffer layer 120.

The separation structure 160 may overlap source electrodes 171 and 172_1 and drain electrodes 191 and 192_1 in the third direction (Z direction). The separation structure 160 may contact bottom surfaces of the source electrodes 171 and 172_1 and bottom surfaces of the drain electrodes 191 and 192_1, but the present disclosure is not limited thereto.

In some examples, the separation structure 160 may be formed by forming the barrier layers 1361 and 1362 on the channel layers 1321 and 1322 and performing an implant process into the barrier layers 1361 and 1362. As another example, gate semiconductor layers 153 and 154_1 may be formed on the barrier layers 1361 and 1362, and after performing an ion implant process on the gate semiconductor layers 153 and 154_1, the gate semiconductor layers 153 and 154_1 may be patterned. Accordingly, the exposed barrier layers 1361 and 1362, channel layers 1321 and 1322, and an ion implanted region of the buffer layer 120 may correspond to the separation structure 160. For example, there may be no or little 2DEG formed in a region of channel layers 1321 and 1322 that overlaps the region where the ion implant process is performed in the barrier layers 1361 and 1362 in the third direction (Z direction). In this case, the ion implant regions of the barrier layers 1361 and 1362 and the corresponding regions of the channel layers 1321 and 1322 may correspond to the separation structure 160. As another example, the separation structure 160 may be formed by performing an ion implant process in the channel layers 1321 and 1322. The ion implanted region in the channel layers 1321 and 1322 may correspond to the separation structure 160. In the region of the channel layers 1321 and 1322 where the ion implant process was performed, a 2DEG may be absent or hardly formed. A material used in the ion implant process may be argon (Ar) ion. In some implementations, the separation structure 160 may be formed by forming the barrier layers 1361 and 1362 on the channel layers 1321 and 1322, forming a trench penetrating the barrier layers 1361 and 1362, and then filling the trench with an insulating material. The insulating material constituting the separation structure 160 may include the same material as the first protective layer 140 and/or the second protective layer 180. For example, the insulating material constituting the separation structure 160 may include an oxide such as SiO₂ or Al₂O₃. As another example, the insulating material constituting the separation structure 160 may include a nitride such as SiN or an oxynitride such as SiON. In some implementations, the insulating material constituting the separation structure 160 may include a material different from the first protective layer 140.

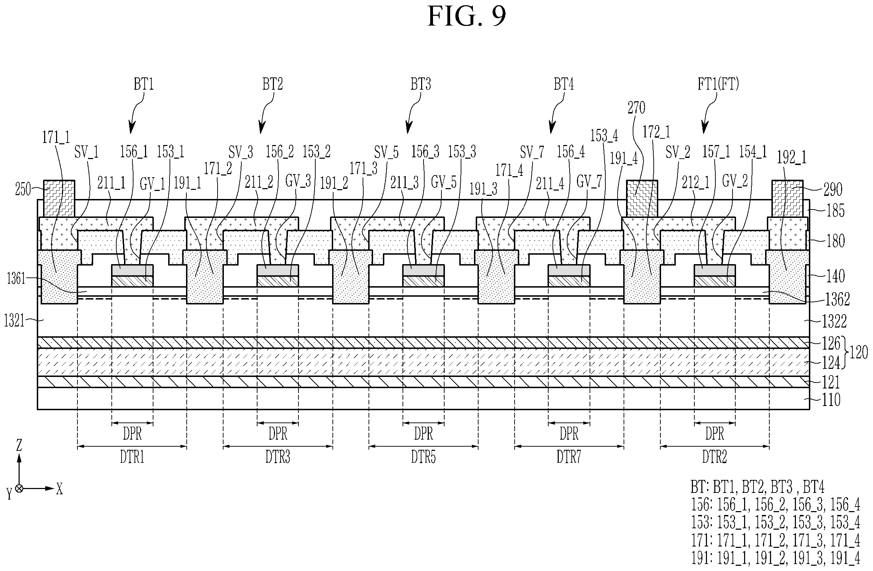

Referring to FIG. 9, the number of backward diodes BT of the semiconductor device may vary. For example, as shown in FIG. 9, the semiconductor device may include four backward diodes BT and one forward diode FT. A first backward diode BT1 to a fourth backward diode BT4 may be coupled in series.

In this case, the second electrode 270 may be electrically connected to a second connection wire 212_1 of the first forward diode FT1. The second electrode 270 may be electrically connected to a first drain electrode 191_4 of the fourth backward diode BT4 and a second source electrode 172_1 of the first forward diode FT1 through the second connection wire 212_1. The second electrode 270 may be in contact with an upper surface of the second connection wire 212_1, but the present disclosure is not limited thereto.

A first source electrode 171_4 of the fourth backward diode BT4 may be integrally formed with a first drain electrode 191_3 of the third backward diode BT3. The first drain electrode 191_4 of the fourth backward diode BT4 may be integrally formed with the second source electrode 172_1 of the first forward diode FT1. The description of this is substantially the same as the description of the backward diodes BT and forward diode FT of the example of FIG. 1 to FIG. 6, and therefore repeated description is omitted.

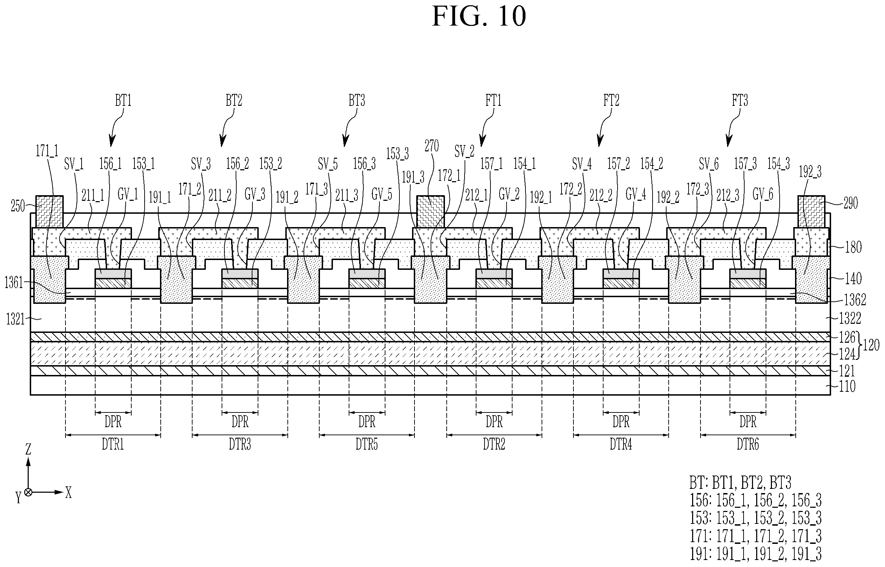

Referring to FIG. 10, in some implementations, the number of backward diodes BT and the number of forward diodes FT may be equal.

For example, as shown in FIG. 10, a semiconductor device may include a first backward diode BT1 to a third backward diode BT3 and a first forward diode FT1 to a third forward diode FT3. The first backward diode BT1 to the third backward diode BT3 and the first forward diode FT1 to the third forward diode FT3 may be composed of the diode units (TU in FIG. 2) of the examples of FIG. 2 and FIG. 3.

The description of the components of the first backward diode BT1 to the third backward diode BT3 and the first forward diode FT1 to the third forward diode FT3 may be applied mostly identically or similarly to the description of the components of the corresponding diode unit (TU of FIG. 2). In the following, duplicate descriptions will be omitted, and the differences will be mainly explained.

The first forward diode FT1 to the third forward diode FT3 may be coupled in series. For example, a second drain electrode 192_1 of the first forward diode FT1 may be integrally formed with a second source electrode 172_2 of the second forward diode FT2, and a second drain electrode 192_2 of the second forward diode FT2 may be integrally formed with a second source electrode 172_3 of the third forward diode FT3. The third electrode 290 may be integrally formed with a second drain electrode 192_3 of the third forward diode FT3.

Accordingly, a threshold voltage of the entire plurality of forward diode FT may be the sum of a threshold voltage of each connected forward diode. For example, the threshold voltages of the entire first forward diode FT1 to the third forward diode FT3 may be the sum of the threshold voltages of the first forward diode FT1 to the third forward diode FT3. Meanwhile, each of the plurality of forward diodes FT may have substantially the same threshold voltage. Therefore, the threshold voltage of the entire first forward diode FT1 to the third forward diode FT3 may be substantially equal to the product of the threshold voltage of any one forward diode times the number of forward diodes coupled in series. For example, the threshold voltage of the entire first forward diode FT1 to the third forward diode FT3 may be 3 V to 3.9 V, but the present disclosure is not limited thereto.

In some examples, the threshold voltage of the entire plurality of forward diodes FT may be substantially the same as the threshold voltage of the entire plurality of backward diodes BT. Accordingly, the semiconductor device according to some examples may serve as a bidirectional diode element having a breakdown voltage not only at a predetermined magnitude of backward voltage but also at a predetermined magnitude of forward voltage.

Referring to FIG. 11 and FIG. 12, gate vias GV_1, GV_3, GV_5, and GV_2 of the semiconductor device may have various shapes.

The gate vias GV_1, GV_3, GV_5, and GV_2 may be arranged along the first direction (X direction). The gate vias GV_1, GV_3, GV _5, and GV_2 may overlap gate electrodes 156 and 157_1 in the third direction (Z direction). The first connection wires 211_1, 211_2, and 211_3 may be disposed in the first gate vias GV_1, GV_3, and GV_5, and the second connection wire 212_1 may be disposed in the second gate via GV_2.

For example, as shown in FIG. 11, lengths of the gate vias GV_1, GV_3, GV_5, and GV_2 in the second direction (Y direction) may be shorter than lengths of a first gate electrode 156 and a second gate electrode157_1 in the second direction (Y direction). In addition, the lengths of the gate vias GV_1, GV_3, GV_5, and GV_2 in the second direction (Y direction) may be shorter than lengths of source vias SV_1, SV_3, SV_5, and SV_2 in the second direction (Y direction). In addition, the lengths of the gate vias GV_1, GV_3, GV_5, and GV_2 in the second direction (Y direction) may be shorter than lengths of a first source electrode 171 and a second source electrode 172_1 in the second direction (Y direction).

As another example, as shown in FIG. 12, the semiconductor device 100 may further include a dummy area DA disposed at one side of the first source electrode 171 and the second source electrode 172_1, and the gate vias GV_1, GV_3, GV_5, and GV_2 may be disposed in the dummy area DA.

The first gate electrode 156 and the second gate electrode 157_1 and the first connection wire 211 and the second connection wire 212_1 may be disposed in the dummy area DA. That is, the first gate electrode 156 and the second gate electrode 157_1 and the first connection wire 211 and the second connection wire 212_1 may further extend in the dummy area DA. The first connection wire 211 may fill the first gate vias GV_1, GV_3, and GV_5 in the dummy area DA. The first connection wire 211 may be electrically connected with the first gate electrode 156 through the first gate vias GV_1, GV_3, and GV_5 in the dummy area DA. In addition, the second connection wire 212_1 may fill the second gate via GV_2 in the dummy area DA. The second connection wire 212_1 may be electrically connected with the second gate electrode 157_1 through the second gate via GV_2 in the dummy area DA.

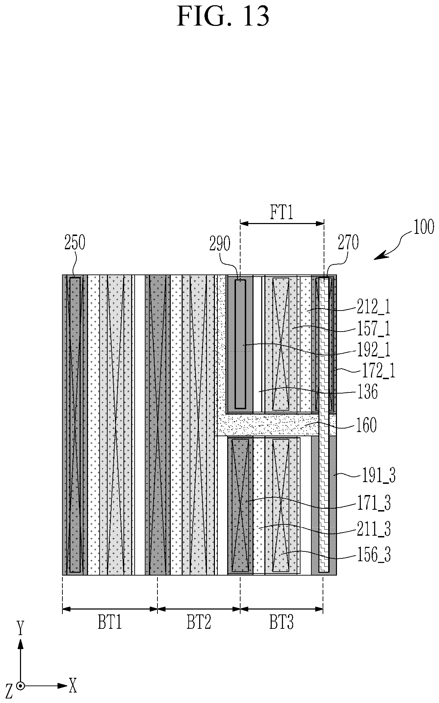

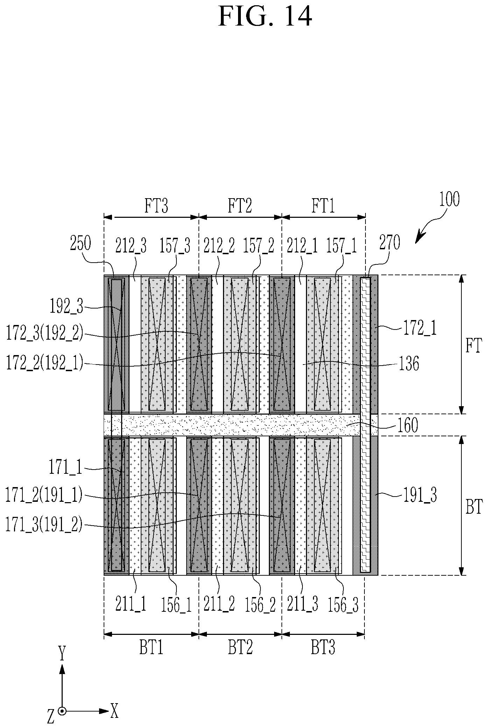

Referring to FIG. 13 and FIG. 14, the arrangement of a plurality of backward diodes BT and at least one forward diode FT of the semiconductor device may vary.

For example, as shown in FIG. 13, the first backward diode BT1 may be disposed at one side of the second backward diode BT2 in the first direction (X direction), and the third backward diode BT3 may be disposed at the other side of the second backward diode BT2 in the first direction (X direction). In this case, a length of the third backward diode BT3 in the second direction (Y direction) may be shorter than a length of the first backward diode BT1 in the second direction (Y direction), but the present disclosure is not limited thereto.

In addition, the first forward diode FT1 may be disposed at one side of the third backward diode BT3 in the second direction (Y direction). That is, the first forward diode FT1 may be disposed at the other side of the second backward diode BT2 in the first direction (X direction). In this case, the first forward diode FT1 and the second backward diode BT2 may be disposed apart from each other. A separation structure 160 may be disposed between the first forward diode FT1 and the second backward diode BT2.

In some implementations, the second source electrode 172_1 of the first forward diode FT1 may be disposed apart from the first drain electrode 191_3 of the third backward diode BT3. The separation structure 160 may be disposed between the second source electrode 172_1 of the first forward diode FT1 and the first drain electrode 191_3 of the third backward diode BT3. The second source electrode 172_1 of the first forward diode FT1 and the first drain electrode 191_3 of the third backward diode BT3 may be separated by the separation structure 160. The remaining description of the separation structure 160 is substantially the same as the description of the separation structure 160 in the example of FIG. 8, and therefore it will be omitted.

In some examples, the second electrode 270 may be electrically connected to each of the second connection wire 212_1 of the first forward diode FT1 and the first drain electrode 191_3 of the third backward diode BT3.

As another example, as shown in FIG. 14, a semiconductor device 100 includes a first backward diode BT1 to a third backward diode BT3 and a first forward diode FT1 to a third forward diode FT3, and the first backward diode BT1 to the third backward diode BT3 and the first forward diode FT1 to the third forward diode FT3 may be disposed adjacent to each other in a second direction (Y direction). For example, the first backward diode BT1 and the first forward diode FT1 may be disposed adjacent to each other in the second direction (Y direction), the second backward diode BT2 and the second forward diode FT2 may be disposed adjacent to each other in the second direction (Y direction), and the third backward diode BT3 and the third forward diode FT3 may be disposed adjacent to each other in the second direction (Y direction). In this case, a separation structure 160 may be disposed between the first backward diode BT1 to the third backward diode BT3 and the first forward diode FT1 to the third forward diode FT3. The first backward diode BT1 to the third backward diode BT3 and the first forward diode FT1 to the third forward diode FT3 may be separated by the separation structure 160.

In some implementations, a semiconductor device 100 may not include a third electrode 290. Specifically, the first electrode 250 may be extended in the second direction (Y direction) and electrically connected to a first connection wire 211_1 of the first backward diode BT1 and a second drain electrode 192_3 of the first forward diode FT1. In addition, the second electrode 270 may be electrically connected to a second connection wire 212_1 of the first forward diode FT1 and a first drain electrode 191_3 of the third backward diode BT3, respectively.

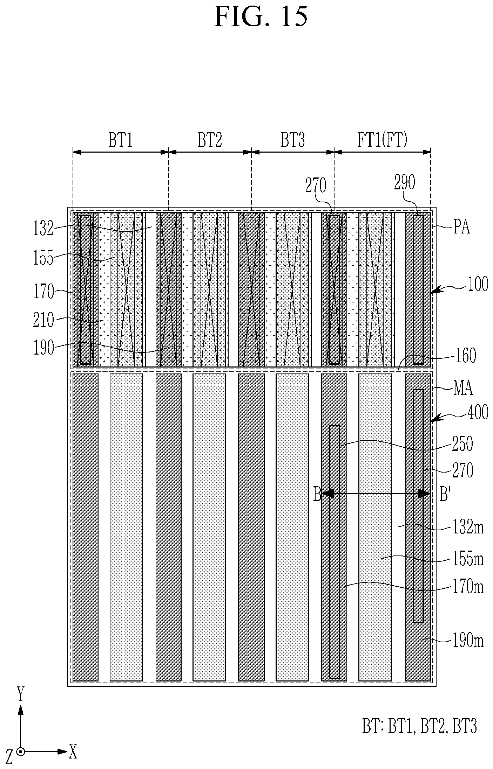

Hereinafter, referring to FIG. 15 to FIG. 17, examples of electronic systems including a semiconductor device will be described.

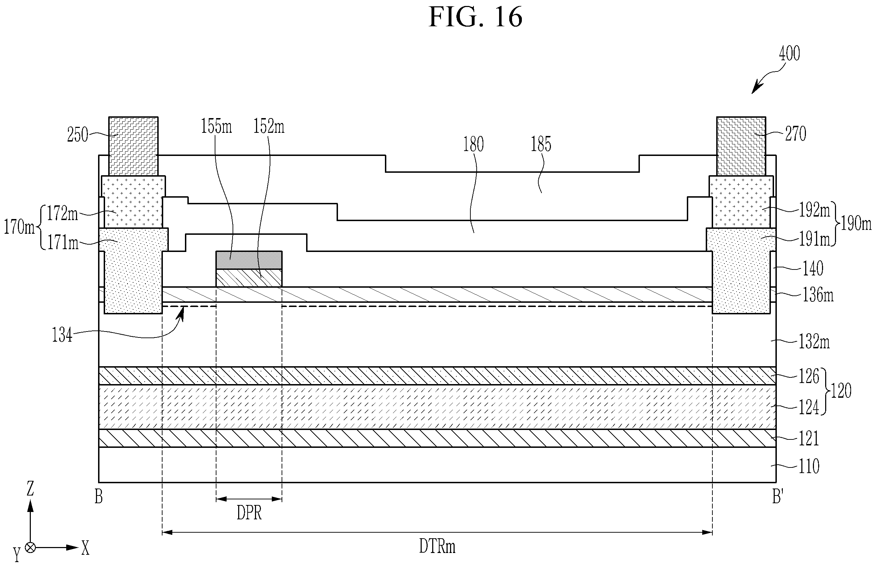

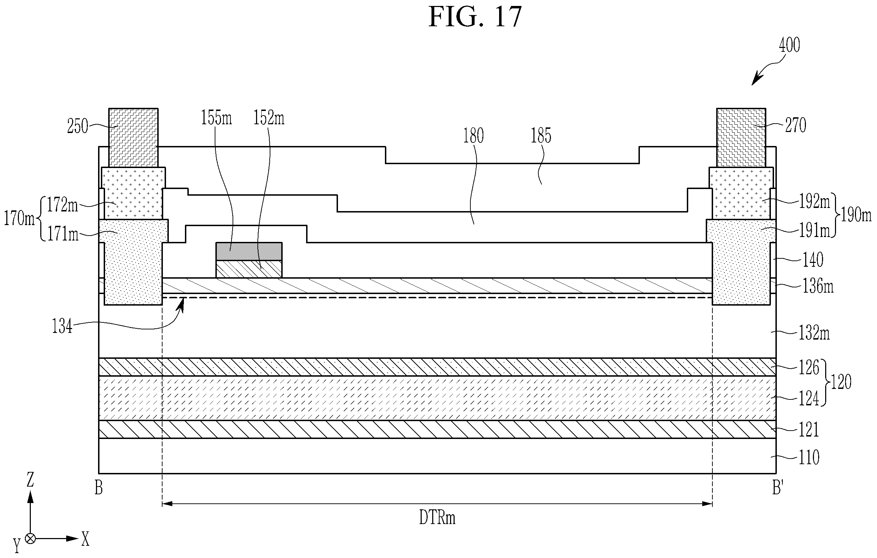

FIG. 15 is a top plan view of an example of an electronic system including a semiconductor device. FIG. 16 and FIG. 17 are cross-sectional views of FIG. 15, taken along the line B-B'. FIG. 16 shows a case that a main transistor element of a semiconductor device is in an off state.

Referring to FIG. 15 to FIG. 16, the electronic system includes a main element area MA including a main transistor element 400 and a peripheral circuit area PA including a semiconductor device, e.g., any of the semiconductor devices 100 of the examples of FIG. 1 to FIG. 14.

The main transistor element 400 may be disposed in the main element area MA. For example, the main transistor element 400 of the electronic system may be a normally-off high electron mobility transistor (HEMT). In some implementations, the main transistor element 400 of the electronic system may be a normally-on HEMT. That is, in some examples, the main element area MA may mean an area where the main transistor element 400 is disposed.

In some examples, elements that are electrically connected with the main transistor element 400 may be disposed in the peripheral circuit area PA of the electronic system. In some examples, the semiconductor device 100 of the examples of FIG. 1 to FIG. 14 may be disposed in the peripheral circuit area PA. The semiconductor device 100 may be electrically connected with the main transistor element 400, but the present disclosure is not limited thereto. The semiconductor device 100 may perform functions of a Zener diode that prevents a voltage of the main transistor element 400 from increasing rapidly. Alternatively, the semiconductor device 100 may be configured with other components to clip the voltage of the main transistor element 400, but the present disclosure is not limited thereto.

In some examples, the peripheral circuit area PA may further include passive components such as capacitors or inductors in addition to the semiconductor device 100, or active components such as an integrated circuit (IC) chip and the like.

As another example, the peripheral circuit area PA may further include a current divider, a voltage divider, a voltage clipper, and protection devices for the main transistor element 400. In some examples, the peripheral circuit area PA may refer to a region where the semiconductor device 100 is disposed.

In some examples, the peripheral circuit area PA of the electronic system may be disposed apart from the main element area MA. For example, the peripheral circuit area PA may be disposed apart from the main element area MA in the second direction (Y direction), but the present disclosure is not limited thereto. As another example, the peripheral circuit area PA may be disposed apart from the main element area MA in the first direction (X direction) or may surround the side of the main element area MA. Other changes are possible. The main transistor element 400 may be disposed within the main element area MA, and the peripheral circuit area PA may include a semiconductor device 100 that is electrically connected to one end of the main transistor element 400.

The main transistor element 400 of the electronic system may include a main channel layer 132m, a main barrier layer 136m disposed on the main channel layer 132m, a main gate electrode 155m disposed on the main barrier layer 136m, a main gate semiconductor layer 152m disposed between the main barrier layer 136m and the main gate electrode 155m, and a main source electrode 170m and a main drain electrode 190m that are disposed at opposite sides of the main gate electrode 155m and connected to the main channel layer 132m.

In some examples, components of the main transistor element 400 may be formed of at least some of components of the semiconductor device 100. The components of the main transistor element 400 may correspond to at least some of the components of the semiconductor device 100. That is, the components of the main transistor element 400 may be composed of at least a portion of the components of the diode units (TU of FIG. 2) of the example of FIG. 2 and FIG. 3. Therefore, the components of the main transistor element 400 may correspond to at least some of the components of the backward diodes BT and the forward diode FT of the examples of FIG. 1 to FIG. 14.

The description of the components of the main transistor element 400 may be applied mostly identically or similarly to the description of the components of the corresponding semiconductor device 100. In the following, duplicate descriptions are omitted, and the differences are mainly explained.

The main channel layer 132m may correspond to the channel layer 132 of the example of FIG. 2 and FIG. 3. The main channel layer 132m is a layer that forms a channel between the main source electrode 170m and the main drain electrode 190m, and a 2-dimensional electron gas (2DEG,) 134 may be disposed inside the main channel layer 132m.

In some examples, the main channel layer 132m may include the same material as the first channel layer 1321 and the second channel layer 1322 and may be disposed in the same layer. For example, the main channel layer 132m may include one or more materials selected from group III-V materials, such as nitrides including Al, Ga, In, B, or a combination thereof. The main channel layer 132m, a first channel layer 1321, and a second channel layer 1322 may be disposed directly above an upper surface of buffer layer 120, but the present disclosure is not limited thereto.

The main channel layer 132m may be disposed on the substrate 110, and a seed layer 121 and the buffer layer 120 may be disposed between the substrate 110 and the main channel layer 132m. Descriptions of the substrate 110, the seed layer 121, and the buffer layer 120 are substantially the same as those of the examples of FIG. 2 and FIG. 3, and therefore repeated descriptions are omitted.

The main barrier layer 136m may correspond to the barrier layer 136 of the example of FIG. 2 and FIG. 3. The main barrier layer 136m may be disposed on the main channel layer 132m. A region of the main channel layer 132m overlapping the main barrier layer 136m between the main source electrode 170m and the main drain electrode 190m may be a main drift region DTRm. The main drift region DTRm may be disposed between the main source electrode 170m and the main drain electrode 190m. The main drift region DTRm may mean a region where carriers move when a potential difference occurs between the main source electrode 170m and the main drain electrode 190m. The electronic system may be turned on/off according to whether or not a voltage is applied to the main gate electrode 155m and/or the magnitude of the voltage applied to the main gate electrode 155m, and carrier movement in the main drift region DTRm may be achieved or blocked according thereto.

In some examples, the main barrier layer 136m may include the same material as the first barrier layer 1361 and the second barrier layer 1362 and may be disposed in the same layer. The main barrier layer 136m may be disposed separately from the first barrier layer 1361 and the second barrier layer 1362. However, the present disclosure is not limited thereto, and the main barrier layer 136m may also be formed integrally with at least a portion of the first barrier layer 1361 and the second barrier layer 1362.

The main gate electrode 155m may correspond to the gate electrode 155 of the example of FIG. 2 and FIG. 3. The main gate electrode 155m may be disposed on the main barrier layer 136m. The main gate electrode 155m may overlap some regions of the main barrier layer 136m in the third direction (Z direction).

The main gate electrode 155m includes the same material as the first gate electrode 156 and the second gate electrode 157_1 and may be disposed in the same layer. The main gate electrode 155m may be disposed apart from the first gate electrode 156 and the second gate electrode 157_1, but the present disclosure is not limited thereto. For example, the main gate electrode 155m may be formed integrally with at least a portion of the first gate electrode 156 and the second gate electrode 157_1. In this case, the integrally formed gate electrode may overlap with the separation structure 160 in the third direction (Z direction), but the present disclosure is not limited thereto.

In some implementations, a hard mask layer disposed on the main gate electrode 155m may further be included. The hard mask layer may be a hard mask used when patterning the gate electrode material layer or gate semiconductor layer during a process of forming the main gate electrode 155m. However, the hard mask layer may be removed depending on etch conditions during etching of the gate electrode material layer or gate semiconductor layer or depending on cleaning conditions after etching. For example, the hard mask layer may include silicon oxide, silicon nitride, silicon oxynitride, or a combination thereof.

The main gate semiconductor layer 152m may correspond to the gate semiconductor layer 152 of the example of FIG. 2 and FIG. 3. The main gate semiconductor layer 152m may be disposed between the main barrier layer 136m and the main gate electrode 155m. A depletion region DPR may be formed within the main channel layer 132m by the main gate semiconductor layer 152m. As the depletion region DPR occurs, a current does not flow between the main source electrode 170m and the main drain electrode 190m, and a channel path may be blocked. Accordingly, the main transistor element 400 of the electronic system may have a normally-off characteristic.

That is, the main transistor element 400 of the electronic system may be a normally-off high electron mobility transistor (HEMT). As shown in FIG. 16, in a normal state where no voltage is applied to the main gate electrode 155m, the depletion region DPR exists and the main transistor element 400 may be in the off state. As shown in FIG. 17, when a voltage higher than the threshold voltage is applied to the main gate electrode 155m, the depletion region DPR disappears, and a 2DEG 134 may be connected without being disconnected within the main drift region DTRm. That is, the main transistor element 400 may be turned on.

The main gate semiconductor layer 152m includes the same material as the first gate semiconductor layer 153 and the second gate semiconductor layer 154_1 and may be disposed in the same layer. The main gate semiconductor layer 152m may be disposed apart from the first gate semiconductor layer 153 and the second gate semiconductor layer 154_1, but the present disclosure is not limited thereto. For example, the main gate semiconductor layer 152m may be formed integrally with at least a portion of the first gate semiconductor layer 153 and the second gate semiconductor layer 154_1. In this case, the integrally formed gate semiconductor layer may overlap the separation structure 160 in the third direction (Z direction), but the present disclosure is not limited thereto.

The electronic system may further include a first protective layer 140 disposed on the main barrier layer 136m and a second protective layer 180 disposed on the first protective layer 140. The first protective layer 140 may correspond to the first protective layer 140 of the example of FIG. 2 and FIG. 3, and the second protective layer 180 may correspond to the second protective layer 180 of the example of FIG. 2 and FIG. 3.

The main source electrode 170m and the main drain electrode 190m may be disposed on the main channel layer 132m. The main source electrode 170m and the main drain electrode 190m may be in direct contact with the main channel layer 132m and may be electrically connected to the main channel layer 132m.

In some examples, the main source electrode 170m may include a first main source electrode 171m and a second main source electrode 172m sequentially disposed on the main channel layer 132m, and the main drain electrode 190m may include a first main drain electrode 191m and a second main drain electrode 192m disposed on the main channel layer 132m.

The first main source electrode 171m and the first main drain electrode 191m may be in contact with an upper surface of the main channel layer 132m. The first main source electrode 171m and the first main drain electrode 191m may correspond to the source electrode 170 and the drain electrode 190 of the example of FIG. 2 and FIG. 3.

The first main source electrode 171m may include the same material as the first source electrode 171 and the second source electrode 172_1 and may be disposed in the same layer. The first main source electrode 171m may be disposed apart from the first source electrode 171 and the second source electrode 172_1, but the present disclosure is not limited thereto. For example, the first main source electrode 171m may be formed integrally with at least a portion of the first source electrode 171 and the second source electrode 172_1.

In this case, the integrally formed source electrode may overlap the separation structure 160 in the third direction (Z direction), but the present disclosure is not limited thereto.

The first main drain electrode 191m may include the same material as the first drain electrode 191 and the second drain electrode 192_1, and may be disposed in the same layer. The first main drain electrode 191m may be disposed apart from the first drain electrode 191 and the second drain electrode 192_1, but the present disclosure is not limited thereto. For example, the first main drain electrode 191m may be formed integrally with at least a portion of the first drain electrode 191 and the second drain electrode 192_1. In this case, the integrally formed drain electrode may overlap the separation structure 160 in the third direction (Z direction), but the present disclosure is not limited thereto.

The second main source electrode 172m may be disposed on the first main source electrode 171m. The second main source electrode 172m may correspond to the upper source electrode 175 of the example of FIG. 2 and FIG. 3. The second main source electrode 172m may include the same material as the first connection wires 211_1, 211_2, and 211_3 and the second connection wire 212_1 and may be disposed in the same layer. The second main source electrode 172m may be disposed apart from the first connection wires 211_1, 211_2, and 211_3 and the second connection wire 212_1, but the present disclosure is not limited thereto. For example, the second main source electrode 172m may be formed integrally with the first connection wires 211_1, 211_2, and 211_3 and at least a portion of the second connection wire 212_1.

The second main drain electrode 192m may be disposed on the first main drain electrode 191m. The second main drain electrode 192m may correspond to the upper drain electrode 195 of the example of FIG. 2 and FIG. 3. The second main drain electrode 192m may include the same material as the first connection wires 211_1, 211_2, and 211_3 and the second connection wire 212_1 and may be disposed in the same layer. The second main drain electrode 192m may be disposed apart from the first connection wires 211_1, 211_2, and 211_3 and the second connection wire 212_1, but the present disclosure is not limited thereto. For example, the second main drain electrode 192m may be formed integrally with the first connection wires 211_1, 211_2, and 211_3 and at least a portion of the second connection wire 212_1.

The electronic system may further include a separation structure disposed between the semiconductor device 100 and the main transistor element 400.

In some examples, the semiconductor device 100 may be separated from the main transistor element 400 by a separation structure 160. For example, as shown in FIG. 15, the main transistor element 400 and the semiconductor device 100 may be disposed apart from each other in the second direction (Y direction) by the separation structure, but the present disclosure is not limited thereto. The separation structure according to some examples may correspond to the separation structure 160 of the example of FIG. 8.

In some examples, the separation structure may penetrate the main barrier layer 136m. For example, the separation structure may recess at least a portion of the substrate 110 through the main barrier layer 136m, the main channel layer 132m, the seed layer 121, and the buffer layer 120. In some implementations, the separation structure may penetrate only the main barrier layer 136m and be disposed on the main channel layer 132m. As another example, the separation structure may penetrate the main barrier layer 136m. As another example, the separation structure may penetrate the main barrier layer 136m and the main channel layer 132m, and recess at least a portion of the buffer layer 120. The remaining description of the separation structure is substantially the same as the description of the separation structure 160 of the example of FIG. 8, and therefore repeated description will be omitted.

The main transistor element 400 of the electronic system may further include a first electrode 250 disposed on the source electrode 170 and a second electrode 270 disposed on the drain electrode 190.

The first electrode 250 may be electrically connected with the source electrode 170, and the second electrode 270 may be electrically connected with the drain electrode 190. The first electrode 250 may correspond to the first electrode 250 of the example of FIG. 4, and the second electrode 270 may correspond to the second electrode 270 of the example of FIG. 4. In other examples, the arrangement of the first electrode 250 and the second electrode 270 may be changed in various ways. For example, the first electrode 250 may be electrically connected with the drain electrode 190, and the second electrode 270 may be electrically connected with the source electrode 170.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Although embodiments have been described in detail above, the scope of the present disclosure is not limited thereto, and various modifications of a person of ordinary skill in the art using the basic concept of the present disclosure defined in the following claims range and Improved forms also fall within the scope of the present disclosure.

Embodiments are set out in the following clauses:
Clause 1. A semiconductor device comprising:
   a substrate;
   a first electrode, a second electrode, and a third electrode on the substrate;
   a plurality of backward diodes connecting the first electrode and the second electrode; and
   at least one forward diode connecting the second electrode and the third electrode,
   wherein the plurality of backward diodes comprises:
      a first channel layer on the substrate;
      a first barrier layer on the first channel layer, the first barrier layer having an energy band gap different from the first channel layer;
      a first gate electrode on the first barrier layer;
      a first gate semiconductor layer between the first barrier layer and the first gate electrode; and
      a first source electrode and a first drain electrode that are disposed at opposite sides of the first gate electrode and connected to the first channel layer,
   wherein the first source electrode is connected with the first gate electrode,
   wherein the at least one forward diode comprises:
      a second channel layer on the substrate, the second channel layer including a same material as the first channel layer;
      a second barrier layer on the second channel layer, the second barrier layer including a same material as the first barrier layer;
      a second gate electrode on the second barrier layer;
      a second gate semiconductor layer between the second barrier layer and the second gate electrode, the second gate semiconductor layer including a same material as the first gate semiconductor layer; and
      a second source electrode and a second drain electrode that are disposed at opposite sides of the second gate electrode and connected to the second channel layer,
   wherein the second source electrode is connected with the second gate electrode,
   wherein the first source electrode of a backward diode of the plurality of backward diodes is connected with the first electrode,
   wherein the first drain electrode of another backward diode of the plurality of backward diodes is connected with the second electrode and a second source electrode of a forward diode of the at least one forward diode, and
   wherein the second drain electrode of a forward diode of the at least one forward diode is connected with the third electrode.
Clause 2. The semiconductor device of clause 1, wherein the first electrode is connected with the third electrode.
Clause 3. The semiconductor device of clause 1 or clause 2, further comprising:
   a first protective layer covering the first barrier layer; and
   a first connection wire on the first protective layer, the first connection wire connecting the first source electrode and the first gate electrode,
   wherein a first source electrode of a backward diode of the plurality of backward diodes is connected with the first electrode through the first connection wire.
Clause 4. The semiconductor device of clause 3, wherein the first electrode, the second electrode, and the third electrode are disposed on a same layer with each other.
Clause 5. An electronic system comprising:
   a substrate;
   a semiconductor device on the substrate, the semiconductor device including a plurality of backward diodes connected with each other and at least one forward diode connected with a backward diode of the plurality of backward diodes; and
   a main transistor element connected with the semiconductor device on the substrate,
   wherein the plurality of backward diodes comprises:
      a first channel layer disposed on the substrate and containing GaN;
      a first barrier layer disposed on the first channel layer and containing AlGaN;
      a first gate electrode disposed on the first barrier layer;
      a first gate semiconductor layer that is disposed between the first barrier layer and the first gate electrode and contains GaN doped with a P-type impurity; and
      a first source electrode and a first drain electrode that are disposed at opposite sides of the first gate electrode and connected with the first channel layer,
   wherein the first source electrode is connected with the first gate electrode,
   wherein the at least one forward diode comprises:
      a second channel layer that is disposed on the substrate and contains GaN;
      a second barrier layer that is disposed on the second channel layer and contains AlGaN;
      a second gate electrode disposed on the second barrier layer;
      a second gate semiconductor layer that is disposed between the second barrier layer and the second gate electrode and that contains GaN doped with a P-type impurity; and
      a second source electrode and a second drain electrode that are disposed at opposite sides of the second gate electrode and connected with the second channel layer,
   wherein the second source electrode is connected with the second gate electrode,
   wherein the first drain electrode of a backward diode of the plurality of backward diodes is connected with a second source electrode of a forward diode of the at least one forward diode, and
   wherein the main transistor element comprises:
      a main channel layer that is disposed on the substrate and includes a same material as the first channel layer;
      a main barrier layer that is disposed on the main channel layer and includes a same material as the first barrier layer;
      a main gate electrode disposed on the main barrier layer;
      a main gate semiconductor layer disposed between the main barrier layer and the main gate electrode; and
      a main source electrode and a main drain electrode that are disposed at opposite sides of the main gate electrode, connected with the main channel layer, and include a same materials as the first source electrode and the first drain electrode.

## Claims

1. A semiconductor device comprising:
a substrate; and
a plurality of backward diodes and at least one forward diode on the substrate,
wherein the plurality of backward diodes comprises:
a first channel layer disposed on the substrate;
a first barrier layer that is disposed on the first channel layer and has an energy bandgap different from an energy band gap of the first channel layer;
a first gate electrode disposed on the first barrier layer;
a first gate semiconductor layer disposed between the first barrier layer and the first gate electrode; and
a first source electrode and a first drain electrode that are disposed at opposite sides of the first gate electrode and connected to the first channel layer, wherein the first source electrode is connected with the first gate electrode,
wherein the at least one forward diode comprises:
a second channel layer disposed on the substrate;
a second barrier layer that is disposed on the second channel layer and has an energy band gap is different from an energy band gap of the second channel layer;
a second gate electrode disposed on the second barrier layer;
a second gate semiconductor layer disposed between the second barrier layer and the second gate electrode; and
a second source electrode and a second drain electrode that are disposed at opposite sides of the second gate electrode and connected to the second channel layer,
wherein the second source electrode is connected to the second gate electrode, and
wherein the first drain electrode of a backward diode of the plurality of backward diodes is connected with the second source electrode of a forward diode of the at least one forward diode.

2. The semiconductor device of claim 1, wherein the first source electrode of another backward diode of the plurality of backward diodes is connected with the second drain electrode of the forward diode of the at least one forward diode.

3. The semiconductor device of claim 1 or claim 2, wherein the plurality of backward diodes comprise a first backward diode and a second backward diode,
wherein the at least one forward diode comprises a first forward diode,
wherein the first drain electrode of the first backward diode is connected with the first source electrode of the second backward diode, and
wherein the first drain electrode of the second backward diode is connected with the second source electrode of the first forward diode.

4. The semiconductor device of claim 3, wherein the first drain electrode of the first backward diode comprises a same material as the first source electrode of the second backward diode and is integrally formed with the first source electrode, and
wherein the first drain electrode of the second backward diode comprises a same material as the second source electrode of the first forward diode and is integrally formed with the second source electrode.

5. The semiconductor device of claim 3 or claim 4, further comprising:
a first electrode connected with the first source electrode of the first backward diode; and
a second electrode connected with the first drain electrode of the second backward diode,
wherein the first electrode is connected with a second drain electrode of the first forward diode.

6. The semiconductor device of any preceding claim, further comprising a first protective layer covering the first barrier layer, the first gate electrode, the second barrier layer, and the second gate electrode,
wherein the first source electrode and the first drain electrode extend through the first protective layer and the first barrier layer and are connected with the first channel layer, and
wherein the second source electrode and the second drain electrode extend through the first protective layer and the second barrier layer and are connected with the second channel layer.

7. The semiconductor device of claim 6, further comprising:
a first connection electrode that is disposed on the 1irst protective layer and connects the first source electrode and the first gate electrode; and
a second connection electrode that is disposed on the first protective layer and connects the second source electrode and the second gate electrode,
wherein the first connection electrode and the second connection electrode are disposed on a same layer as each other and include a same material as each other.

8. The semiconductor device of claim 7, further comprising a second protective layer disposed on the first protective layer,
wherein the first connection electrode and the second connection electrode are disposed on the second protective layer.

9. The semiconductor device of claim 8, wherein the first connection electrode is connected to the first source electrode by extending through the second protective layer and is connected to the first gate electrode by extending through the second protective layer and the first protective layer, and
wherein the second connection electrode is connected to the second source electrode by extending through the second protective layer and connected to the second gate electrode by extending through the second protective layer and the first protective layer.

10. The semiconductor device of any of claims 7-9, wherein the first source electrode and the first connection electrode are integrally formed with each other, and
wherein the second source electrode and the second connection electrode are integrally formed with each other.

11. The semiconductor device of any preceding claim, wherein the first channel layer and the second channel layer are integrally formed with each other, and
wherein the first barrier layer and the second barrier layer are integrally formed with each other.

12. The semiconductor device of claim 11, wherein the first source electrode, the first drain electrode, the second source electrode, and the second drain electrode are disposed on a same layer as each other and include a same material as each other.

13. The semiconductor device of any preceding claim, wherein a threshold voltage of each of the plurality of backward diodes is a same as a threshold voltage of each of the at least one forward diode.

14. The semiconductor device of claim 13, wherein the threshold voltage of each of the plurality of backward diodes is 1 V to 1.3 V.

15. The semiconductor device of any preceding claim, wherein a number of the plurality of backward diodes is equal to a number of the at least one forward diode.

## Amended claims

### Amended claims in accordance with Rule 137(2) EPC.

1. A Zener diode (100) comprising:
a substrate (110); and
a plurality of backward diodes (BT) configured to conduct under reverse bias of the Zener diode and at least one forward diode (FT) configured to conduct under forward bias of the Zener diode, on the substrate (110),
wherein the plurality of backward diodes (BT) comprises:
a first channel layer (1321) disposed on the substrate (110);
a first barrier layer (1361) that is disposed on the first channel layer (1321) and has an energy bandgap different from an energy band gap of the first channel layer (1321);
a first gate electrode (156) disposed on the first barrier layer (1361);
a first gate semiconductor layer (153) disposed between the first barrier layer (1361) and the first gate electrode (156); and
a first source electrode (171) and a first drain electrode (191) that are disposed at opposite sides of the first gate electrode (156) and connected to the first channel layer (1321), wherein the first source electrode (171) is connected with the first gate electrode (156),
wherein each of the plurality of backward diodes (BT) is formed of a first high electron mobility transistor, HEMT, comprising the first channel layer (1321), the first barrier layer (1361), the first gate electrode (156) and the first gate semiconductor layer (153),
wherein the at least one forward diode (FT) comprises:
a second channel layer (1322) disposed on the substrate (110);
a second barrier layer (1362) that is disposed on the second channel layer (1322) and has an energy band gap is different from an energy band gap of the second channel layer (1322);
a second gate electrode (157_1) disposed on the second barrier layer (1362);
a second gate semiconductor layer (154_1) disposed between the second barrier layer (1362) and the second gate electrode (157_1); and
a second source electrode (172_1) and a second drain electrode (192_1) that are disposed at opposite sides of the second gate electrode (157_1) and connected to the second channel layer (1322),
wherein each of the at least one forward diode (FT) is formed of a second HEMT comprising the second channel layer (1322), the second barrier layer (1362), the second gate electrode (157_1) and the second gate semiconductor layer (154_1),
wherein the second source electrode (172_1) is connected to the second gate electrode (157_1), and
wherein the first drain electrode (191) of a backward diode (BT) of the plurality of backward diodes (BT) is connected with the second source electrode (172_1) of a forward diode (FT) of the at least one forward diode (FT).

2. The Zener diode (100) of claim 1, wherein the first source electrode (171) of another backward diode (BT) of the plurality of backward diodes (BT) is connected with the second drain electrode (192_1) of the forward diode (FT) of the at least one forward diode (FT).

3. The Zener diode (100) of claim 1 or claim 2, wherein the plurality of backward diodes (BT) comprise a first backward diode (BT2) and a second backward diode (BT3),
wherein the at least one forward diode (FT) comprises a first forward diode (FT1),
wherein the first drain electrode (191_2) of the first backward diode (BT2) is connected with the first source electrode (171_3) of the second backward diode (BT3), and
wherein the first drain electrode (191_3) of the second backward diode (BT3) is connected with the second source electrode (172_1) of the first forward diode (FT1).

4. The Zener diode (100) of claim 3, wherein the first drain electrode (191_2) of the first backward diode (BT2) comprises a same material as the first source electrode (171_3) of the second backward diode (BT3) and is integrally formed with the first source electrode (171_3), and
wherein the first drain electrode (191_3) of the second backward diode (BT3) comprises a same material as the second source electrode (172_1) of the first forward diode (FT1) and is integrally formed with the second source electrode (172_1).

5. The Zener diode (100) of claim 3 or claim 4, further comprising:
a first electrode (250) connected with the first source electrode (171_2) of the first backward diode (BT2); and
a second electrode (270) connected with the first drain electrode (191_3) of the second backward diode (BT3),
wherein the first electrode (250) is connected with a second drain electrode (192_1) of the first forward diode (FT1).

6. The Zener diode (100) of any preceding claim, further comprising a first protective layer (140) covering the first barrier layer (1361), the first gate electrode (156), the second barrier layer (1362), and the second gate electrode (157_1),
wherein the first source electrode (171) and the first drain electrode (191) extend through the first protective layer (140) and the first barrier layer (1361) and are connected with the first channel layer (1321), and
wherein the second source electrode (172_1) and the second drain electrode (192_1) extend through the first protective layer (140) and the second barrier layer (1362) and are connected with the second channel layer (1322).

7. The Zener diode (100) of claim 6, further comprising:
a first connection electrode (211_1) that is disposed on the first protective layer (140) and connects the first source electrode (171) and the first gate electrode (156); and
a second connection electrode (212_1) that is disposed on the first protective layer (140) and connects the second source electrode (172_1) and the second gate electrode (157_1),
wherein the first connection electrode (211_1) and the second connection electrode (212_1) are disposed on a same layer as each other and include a same material as each other.

8. The Zener diode (100) of claim 7, further comprising a second protective layer (180) disposed on the first protective layer (140),
wherein the first connection electrode (211_1) and the second connection electrode (212_1) are disposed on the second protective layer (180).

9. The Zener diode (100) of claim 8, wherein the first connection electrode (211_1) is connected to the first source electrode (171) by extending through the second protective layer (180) and is connected to the first gate electrode (156) by extending through the second protective layer (180) and the first protective layer (140), and
wherein the second connection electrode (212_1) is connected to the second source electrode (172_1) by extending through the second protective layer (180) and connected to the second gate electrode (157_1) by extending through the second protective layer (180) and the first protective layer (140).

10. The Zener diode (100) of any of claims 7-9, wherein the first source electrode (171) and the first connection electrode (211_1) are integrally formed with each other, and
wherein the second source electrode (172_1) and the second connection electrode (212_1) are integrally formed with each other.

11. The Zener diode (100) of any preceding claim, wherein the first channel layer (1321) and the second channel layer (1322) are integrally formed with each other, and
wherein the first barrier layer (1361) and the second barrier layer (1362) are integrally formed with each other.

12. The Zener diode (100) of claim 11, wherein the first source electrode (171), the first drain electrode (191), the second source electrode (172_1), and the second drain electrode (192_1) are disposed on a same layer as each other and include a same material as each other.

13. The Zener diode (100) of any preceding claim, wherein a threshold voltage of each of the plurality of backward diodes (BT) is a same as a threshold voltage of each of the at least one forward diode (FT).

14. The Zener diode (100) of claim 13, wherein the threshold voltage of each of the plurality of backward diodes (BT) is 1 V to 1.3 V.

15. The Zener diode (100) of any preceding claim, wherein a number of the plurality of backward diodes (BT) is equal to a number of the at least one forward diode (FT).
